(19) Europäisches Patentamt
European Patent Office
Office européen des brevets

(11) **EP 2 951 926 B1**

(12) **EUROPEAN PATENT SPECIFICATION**

(45) Date of publication and mention
of the grant of the patent:
**11.10.2023 Bulletin 2023/41**

(21) Application number: **13704890.6**

(22) Date of filing: **31.01.2013**

(51) International Patent Classification (IPC):
***H03M 13/11*** *(2006.01)*

(52) Cooperative Patent Classification (CPC):
**H03M 13/116; H03M 13/6502**

(86) International application number:
**PCT/EP2013/051830**

(87) International publication number:
**WO 2014/117837 (07.08.2014 Gazette 2014/32)**

(54) **LDPC CODE DESIGN AND ENCODING APPARATUS FOR THEIR APPLICATION**

LDPC CODE DESIGN UND KODIERGERÄT ZUR ANWENDUNG

DESIGN DE CODE DE LDPC CODE ET DISPOSITIF DE CODAGE POUR L'APPLICATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**09.12.2015 Bulletin 2015/50**

(73) Proprietor: **Intracom S.A. Telecom Solutions
19002 Paiania, Athens (GR)**

(72) Inventors:
• **KALATZIS, Charalampos
GR-19002 Paiania
Athens (GR)**
• **PANAYIOTOPOULOS, Ilias
GR-19002 Paiania
Athens (GR)**
• **KORATZINOS, Vassilios
GR-19002 Paiania
Athens (GR)**

• **VALKANAS, Antonios
GR-19002 Paiania
Athens (GR)**
• **TSAKIRIS, Stavros
GR-19002 Paiania
Athens (GR)**

(74) Representative: **Samouilidis, Emmanouil
Alkyonis 46
175 62 Palaio Faliro (GR)**

(56) References cited:
**WO-A1-2010/047662**

• **Wikipedia: "Shift register", WIkipedia, 15 August
2012 (2012-08-15), XP002693984, Retrieved from
the Internet:
URL:http://en.wikipedia.org/w/index.php?ti
tle=Shift_register&oldid=507483627 [retrieved
on 2013-03-18]**

**Description**

The invention relates to design, methods and apparatus for encoding and decoding information binary data through the use of **Low-D**ensity **P**arity **C**heck (LDPC) codes for wireless telecommunication systems.

The continuous growth of high-speed wireless broadband telecommunication systems has been enforced by the increasing demand on more reliable and higher throughput to support novel applications and services. In order to detect and correct corrupted received signals from the wireless propagation medium, noise and interference, Forward Error Correction (FEC) codes that include redundancy in the encoded transmitted data packets are the most suitable solution since no feedback from the receiver to the transmitter is required. Recently, a class of FEC codes named Low-Density Parity Check (LDPC) codes has regain significant interest due to their ability to achieve near-Shannon limit capacity performances, their iterative decoding processing and their capability for parallel execution of certain encoding and decoding operations.

The encoding of LDPC codes is performed using a sparse parity check matrix **H** of size *m* rows and *n* columns with *m<n*. Matrix **H** is characterized as sparse since the majority of its elements are zero (usually with a proportion of zero elements greater than 80% of the total *m·n* elements of matrix **H**). The matrix **H** is a binary matrix composed of zeros and ones. A binary vector $\bar{c}$ of size 1 row by *n* columns is a valid codeword of the LDPC code defined by matrix **H** if the equation $\mathbf{H} \cdot \bar{c}^T = \bar{0}$ in the modulo-2 Galois Field $GF_2$ is satisfied, where $\bar{0}$ denotes the all zero vector of size *m* rows by 1 column and $\bar{c}^T$ the transpose operation on vector $\bar{c}$. This property is characterizing LDPC codes as linear systematic block codes meaning that the input data are included into the encoded data, i.e. the codeword $\bar{c}$. Hence, using row operations, we can rewrite **H** as a function of a matrix **P** and the identity matrix $\mathbf{I_m}$ of size *m* rows by *m* columns, i.e. $\mathbf{H}=[\mathbf{P}|\mathbf{I_m}]$. Therefore, each codeword $\bar{c}$ is composed of the information data bits $\bar{x}$ of size 1 row by *n-m* columns and the parity bits $\bar{p}$ of size 1 row by *m* columns. Hence, the matrix **H** is defining a set of *m* parity check equations each of which involves a specific group of information and parity bits that must sum to zero modulo 2. The code rate of the encoding with a matrix **H** is characterized by the ratio *r* given by the size of the information bits with the size of encoded bit i.e.

$$r = \frac{n-m}{n} = 1 - \frac{m}{n}.$$

All LDPC codes and their matrices **H** can be represented by bipartite graphs also called Tanner graphs. In a Tanner graph, nodes are split into two groups, the variable nodes that are associated to the codeword bits and the check nodes that correspond to the set of parity-check constraints of the code. Variable and check nodes are connected through edges. Each variable node is associated to a column of **H** and each check node to a row of **H**. The presence of a non-zero value, i.e. a 'one' in matrix **H** identifies an edge connection between the variable and check nodes that are associated to the corresponding column and row. A path in a (Tanner) graph is a sequence of nodes such that from each of its nodes there is an edge to the next node in the sequence. A finite path has always a first node called start node and a last node called end node. A cycle is a finite path with its start and end nodes are the same. The girth of a graph is the length of the shortest cycle contained in a graph.

The encoding process of LDPC can be performed using the generator matrix **G** of the code of size *n-m* rows by *n* columns. The generator matrix **G** must satisfies the equation $\mathbf{G} \cdot \mathbf{H}^T = \bar{0}$, where $\bar{0}$ denotes the all zero matrix of size *n-m* rows by *m* columns and $\mathbf{H}^T$ the transpose operation on matrix **H**. Then, for each information data or block of data $\bar{x}$, the codeword $\bar{c}$ of the LDPC code can be obtained by $\bar{c} = \bar{x} \cdot \mathbf{G}$. The vector multiplication with matrix **G** can be parallelized by splitting the multiplication process to operations performed on distinct columns of **G**.

For the decoding of LDPC codes, a general mostly used methodology applied by the decoders is the implementation of an exchanging messages algorithm among registers. This means that the values in registers of the decoders are updated based on a certain algorithm and the values or messages provided by other registers. Then, these updated values correspond to messages provides to other registers for the calculation of their updated values. The registers are associated to the nodes of the Tanner graph of the LDPC code. The connections allowed among registers for the transfer of messages are determined by the edges of the Tanner graph given by the parity check matrix **H.** Initially, each register representing variable nodes are set to values characterizing the estimation of the value of the corresponding codeword bit. Computations in each register are performed based on the incoming messages and the type of node in the Tanner graph. The message exchange process is iteratively repeated until specific conditions are met, for example until the estimations of the codeword bits satisfy the condition $\mathbf{H} \cdot \bar{c}^T = \bar{0}$.

Typically, in LDPC codes, parity check matrices **H** are designed for a particular code rate and for a predetermined codeword length. This means that not only both values *m* and *n* are predetermined but also the ratio value *r* is fixed. This leads to the implementation of a specific architecture at both encoder and decoder that cannot accommodate packets $\bar{x}$ of variable sizes nor support different code rates. Therefore, there is tremendous interest in the dimensioning of generalized LDPC encoding and decoding implementation architectures capable to support various codeword lengths and code rates that can exploit efficient designs and compositions of the parity check matrices **H.**

The international patent application WO2010047662, published 2010-04-29, discloses construction of the check matrice H for LDPC codes based on a base matrix. The first layer matrix of the parity check matrix is given by the base matrix itself. The other layer matrices have the same structure as the first layer matrix of the parity check matrix. Each sub-matrix in the r+lth layer is established by cyclically block shifting the sub-blocks of the corresponding sub-matrix (i.e. the sub-matrix with the same position in the layer matrix) in the rth layer to the right or left, where r=1, 2, ..., R-1 where R is the number of layers and, at the same time, the number of sub-blocks of the sub-matrices.

The object of the invention is an apparatus and a method for the processing of blocks of data bits with Low-Density Parity Check codes, which are efficient and enable simultaneously the selection of encoding parameters that suit the needs of the communication channel and the definition of the parity check matrix without the need of time consuming computations.

The invention is defined in the independent claims.

The invention enables the efficient exploitation of storage capacity of RAMs and the connection buses among components, by performing storage and transfers of several subsets of input bits even for the lower values of the codeword length. In addition, the invention enables parallelization and supports under a unique architecture various codeword lengths and code rates without modification of the implementation and storage requirements.

The processing means of an apparatus according to the invention includes a sign shifter means that is configured to perform flipping operations, i.e. reversing the order of entries, over sets of bits based on a shift parameter obtained by the controller.

The apparatus may include a Sparse Matrix Multiplier (SMM) that is used for consecutive processing of the same block of data or more than one sparse matrix multipliers (SSM's). In the former case the apparatus includes means to receive the output of the SSM and re-direct it to it. The output has the same dimensions as the input. In the latter case the input of a SSM is forwarder to the following. SSM's may be also arranged in parallel.

The shift parameters that define the circulant blocks are obtained from a unique controlling parameters and shift parameters that define a master rectangular block than any of the circulant blocks. Preferably, the apparatus may comprise storage means, which are configured to store the shift parameters defining the master rectangular block, input means configured to obtain the unique controlling parameter and processing means configured to determine the shift parameters from the shift parameters defining the master rectangular block and the unique controlling parameter.

Preferably the parity check matrix, which is used for the encoding is subdivided into $\alpha \times \beta$ rectangular blocks of size q so that the parity check matrix is composed of $q \times \alpha$ rows and $q \times \beta$ columns with $\alpha$ and $\beta$ being non-zero integer positive numbers, the rectangular blocks of size q are further subdivided into $\gamma \times \gamma$ rectangular blocks of size v, so that the rectangular blocks of size q are composed of $v \times \gamma$ rows and $v \times \gamma$ columns with $\gamma$ being non-zero integer positive number and the rectangular blocks of size v are further subdivided into $\delta \times \delta$ rectangular blocks of size w so that the rectangular blocks of size v are composed of $w \times \delta$ rows and $w \times \delta$ columns with $\delta$ being non-zero integer positive number. The user may set a maximum value for $w \times \delta$ for a set of bits and each packet of bits is split into a series of sets of equal number of information bits, whereby each set includes no more than the maximum value $w \times \delta$. The maximum value of $w \times \delta$ could be equal to a power of 2, preferably 32. $\delta$ may be also equal to a power of 2, preferably 8. The code rate can be controlled by selecting the value of $\alpha$. The codeword length, i.e. the number of bits of the codeword may be controlled by the dimensions of q, preferably through the selection of $\delta$. In a preferred embodiment of the invention w is selected equal to 4.

An apparatus or a method according to the invention may comprise one or more of the preferable features in combination.

Embodiments of the invention will be described with reference to **Figures 1 to 8**, whereby:

**Figure 1** shows the composition of the parity check matrix **H** from its sub-matrices **A**, **C**, **B**, **D**, **E** and **T.**
**Figure 2** shows an example of the cyclic representation of 3 Levels of squared blocks of **H**.
**Figure 3** shows an example of positive and negative cyclic shifts of a block.
**Figure 4** shows an example of the compression transformation of square block **of H.**
**Figure 5** shows an example of selection of Level-2 shift values based on value **L**.
**Figure 6** shows an example of rate transformation of sub-matrices **B, D, E, T** and **T**$^{-1}$.
**Figure 7** shows the diagram of the encoding process of the LDPC codes.
**Figure 8** shows the diagram of the multiplication of a sparse matrix multiplier component.

The paragraphs below include a description of the structure and methodology for the construction of LDPC code parity matrices and, the transforms that convert them in order to support variable code rates and codeword lengths following by a description of the encoding architecture that exploit such family of LDPC codes. Examples illustrated by drawings are also given to describe and further clarify the examples of the invention. However, the examples are not limiting the invention that can be used for the definition of a wide variety of families of LDPC codes.

*LDPC Codes Design*

As mentioned at the beginning of this document, channel coding LDPC is mainly characterized by a parity check matrix **H** composed of binary values: zeros and ones. Even though, the composition of matrix **H** can be arbitrary, it is possible through simple row and column permutations to convert it into a format with all zeros into its upper right part (see Thomas J. Richardson and Rüdiger L. Urbanke, «Efficient Encoding of Low-Density Parity-Check Codes», IEEE Transactions on Information Theory, Vol. 47, No. 2, February 2001, pages 638-656). It can then be split into a set of sub-matrices namely **A**, **B**, **C, D, E** and **T**. This partitioning is led by sub-matrix **T** that is defined to be a lower triangular rectangular matrix. According to the dimensions of **T,** the dimensions of sub-matrices **A**, **B**, **C, D,** and **E** can be obtained. The number of non-zero values in these last 5 sub-matrices is arbitrary. In linear block codes such as LDPC, decoding is usually performed using matrix **H** while encoding is performed using the generator matrix **G.** The above mentioned representation of matrix **H** leads to a simple encoding process performed following a series of steps using the sub-matrices of **H,** certain of which can be carried out in parallel. Therefore, a significant advantage of this implementation is that only storage of matrix **H** is required for both encoding and decoding processes. The encoding process based on matrix **H** is described below. Decoding using the above described families of sparse parity matrices **H** can be performed using a typical LDP decoder based on Min-Sum algorithm. In the preferred embodiments of the invention, we define a specific set of constraints to the dimensions and compositions of all sub-matrices of **H** in order to reduce storage requirements, provide support of different code rates and codeword lengths with no modifications of the system architecture, and simplify both encoding and decoding operations. This set of constraints defines a family of parity check matrices **H** with different code rates and different sizes that can be used by a unique encoding and decoding architecture to accommodate variable codeword lengths and code rates.

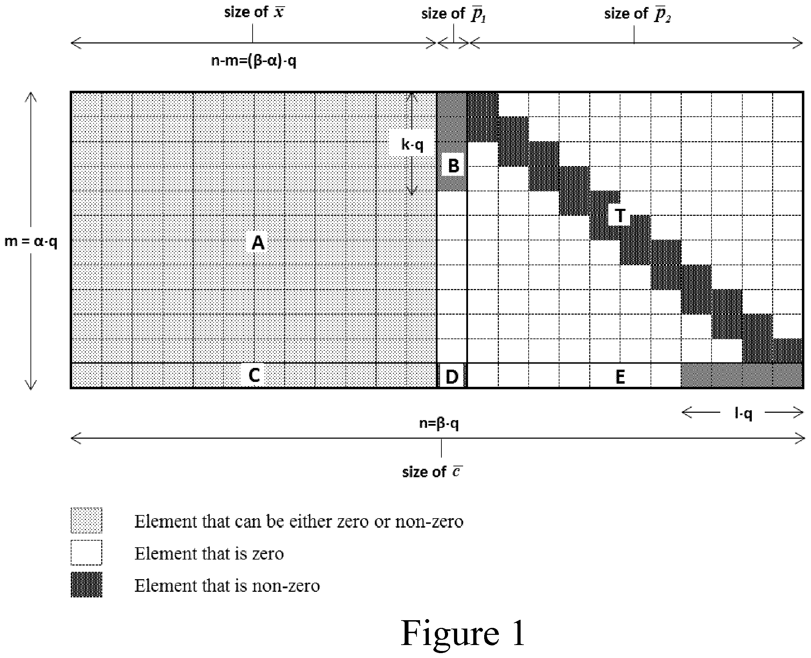

A sparse parity check matrix **H** belonging to a family of parity check matrices is initially determined by its subdivision into rectangular blocks of a predefined size *q,* i.e. having *q* lines and columns. This implies that the dimensions *m* and *n* of matrix **H,** i.e. the number of rows and columns of matrix **H,** are multiples of *q*. Therefore, by naming $\alpha$ the number of rectangular blocks of size *q* across a column of matrix **H** and by $\beta$ of rectangular blocks of size *q* along a row of matrix **H,** i.e. the size of subdivision of matrix **H** is $\alpha \times \beta$, the matrix **H** is subdivided into the following 6 sub-matrices as shown in **Figure 1:**

- matrix **A** of size *($\beta$-$\alpha$)·q* by *($\alpha$-1)·q*
- matrix **B** of size *q* by *($\alpha$-1)·q*
- matrix **C** of size *($\beta$-$\alpha$)·q* by *q*
- matrix **D** of size *q* by *q*
- matrix **E** of size *($\alpha$-1)·q* by *q*
- matrix **T** of size *($\alpha$-1)·q* by *($\alpha$-1)·q*

More analytically, we define a non-zero integer positive number *q* such that matrix **H** of the family of sparse parity check matrices is composed of *q·$\alpha$* rows and *q·$\beta$* columns with $\alpha$ and $\beta$ defined as non-zero integer positive numbers.

The first constraint on the design of the family of matrices **H** is that the number $\beta$ is constraint to a constant value. The support of different codeword lengths through the definition of the size *n* of the family of matrices **H** is determined by controlled modifications of the size *q* as described below. The code rate *r* is defined as the ratio of the

$$r = \frac{n-m}{n} = 1 - \frac{m}{n} = 1 - \frac{\alpha \cdot q}{\beta \cdot q} = 1 - \frac{\alpha}{\beta}$$

information bits lengths divided by the codeword length, i.e. . Since the number $\beta$ is fixed and $\alpha$<$\beta$, the different code rates supported by the system are given by changing $\alpha$ as described in the following paragraphs. The matrices **H** determined by different values of $\alpha$ determine a family of parity matrices of different code rates. For each of these matrices, the matrices **H** obtained by modifications of the size *q* determine a family of parity matrices of different codeword lengths for the code rate determined by the value of $\alpha$. All these matrices determine the general family of matrices supported by the system providing encoding of variable code rate and codeword lengths.

As an implementation example, we consider throughout this document that *$\beta$=24*. Also, we determine a specific set of possible values for $\alpha$ $\in${*12, 6, 5, 4, 3}*. For these values of $\alpha$ and $\beta$, we have the following possible code rates supported by the system *r* $\in${*0.5, 0.75, 0.792, 0.833, 0.875}*.

We define as zero rectangular block, any rectangular matrix that has all its elements equal to zero. Equivalently, any rectangular matrix that has at least one of its elements non-zero is defined as a non-zero rectangular block. In fact, as we will show later on, each non-zero *q* block has exactly *q* non-zero elements. Then, we can define the following set of general constraints on the composition of the sub-matrices of **H** in terms of zero or non-zero blocks of size *q:*

- There is no constraint on the number of non-zero and zero **q** blocks allowed in sub-matrices **A** and **C**.
- Matrix **D** is constraint to be composed of a non-zero **q** block.
- Matrix **T** is constraint to contain non-zero elements only in the **q** blocks of its diagonal and the **q** blocks directly underneath this diagonal as shown in **Figure 1**. This means that if $x$ is the number identifying the column position of a **q** block of T and $y$ is the number identifying the row position of a **q** block **of T**, i.e. $x \in [1; (\alpha\text{-}1)]$ and $y \in [1; (\alpha\text{-}1)]$, then a **q** block contains non-zero elements if and only if the following conditions are satisfied: $x=y$ or $y=x+1$.
- Finally, we define by **k** the number of non-zeros **q** rectangular blocks placed on the top rows of sub-matrix **B** and by I the number of non-zeros **q** rectangular blocks placed in the right columns of sub-matrix **E** as shown in Figure 1. All other **q** rectangular blocks of matrices **B** and **E** are zero blocks. In our implementation example, we set **k=2,** i.e. matrix **B** has only 2 non-zero blocks **q** rectangular blocks placed on the top rows of **B**. Also, we can set **l=1,** i.e. matrix **E** has only 1 non-zero blocks **q** rectangular blocks placed on the right columns of **E.**
- For implementation purposes, we set a general constraint on the total number $\eta$ of non-zero **q** blocks allowed in the entire matrix **H** for all code rates supported. The constraint on $\eta$ is such that the number of non-zero elements in the entire matrix **H** must not exceed $\eta$. With this constraint, the number of encoding and decoding operations that are bounded by the operations performed on the non-zero **q** blocks of the sparse matrices can be predetermined. Since non-zero blocks in matrices **D, T, B** and **E** are constraint, we can determine the number of non-zero blocks allowed in matrices **A** and **C**. This establishes the maximum number of non-zero **q** blocks in all sub-matrices of **H**. For our implementation example, in the case where $\alpha=4$, then the number of non-zero **q** block in matrix **T** are **5.** The number of non-zero blocks in **D, B**, and **E** are 1, 2 and 1 respectively. Hence, by setting our constraint $\eta=85$, the number of non-zero blocks in matrices **A** and **C** is **85-5-2-1-1=76** that are distributed in the **4·(24-4)=80** rectangular **q** blocks of matrices **A** and **C**. Notice, that for $\alpha=3$ and $\eta=85$ the number of non-zero blocks in matrices **A** and **C** is **85-3-2-1-1=78** but the size in **q** blocks of matrices **A** and **C** is **3·(24-3)=63** that is smaller than **78.** In this case, all **q** blocks of matrices **A** and **C** are non-zero blocks.

As described above, we define a specific set of constraints on the design of families of parity matrices **H** and the transformation functions of these matrices **H** targeting the accommodation of codewords of various lengths and various rates. We include an extension of the construction of these matrices **H** aiming to provide additional performance robustness to the LDPC codes.

Based on these constraints and conversions, we propose implementation methods for the encoding of sparse sub-matrices of **H** optimized in terms of operations required and capable to support under a unique architecture various codeword lengths and code rates without modification of the implementation and storage requirements.

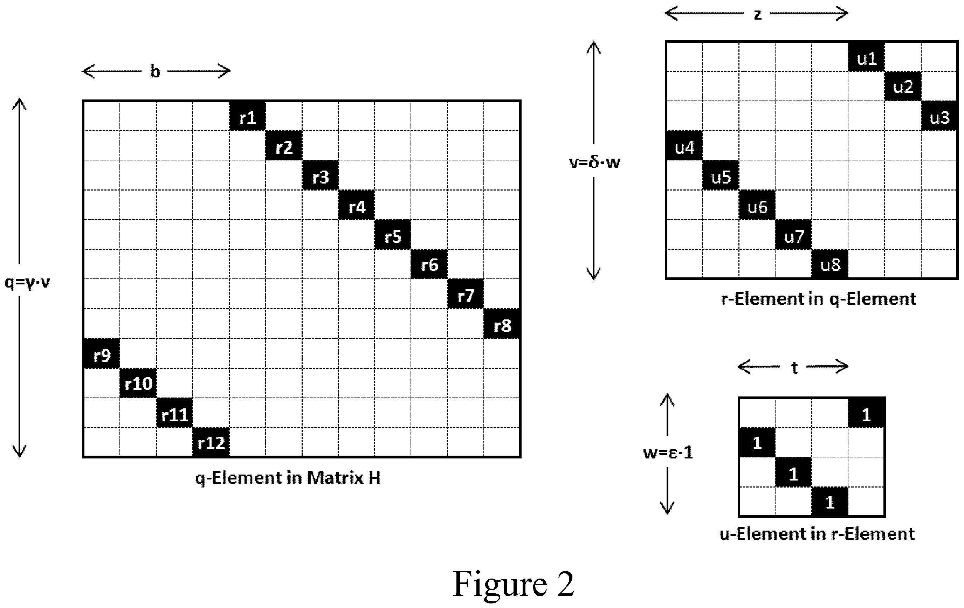

Following the subdivision in rectangular blocks described above, we extend this decomposition by imposing that sparse parity matrix **H** can be subdivided into rectangular blocks of a specific size that can in their turn be subdivided into rectangular blocks of a specific size and so on. We declare that each subdivision of a predefined size and corresponding rectangular blocks define a Level of representation of matrix **H**. The invention suggests at least three subdivisions and consequently 3 Levels of representation of the matrix **H**. Hence, each rectangular block of size **q** of matrix **H** can be further subdivided into rectangular blocks of size v which in their turn can also be subdivided into rectangular blocks of size **w** and so on. In the embodiments of the invention we consider that there are only 3 levels of subdivision of blocks, i.e. a block **q** (Level-1) noticed as q-Element is composed of blocks **v** (Level-2) noticed as r-Elements that are composed of blocks **w** (Level-3) noticed as u-Elements as shown in **Figure 2**. Hence, we can denote by $\gamma$ the number of rectangular blocks of size **v** aligned in each row or column of a block **q,** by $\delta$ the number of rectangular blocks of size **w** aligned in each row or column of a block **v** and by $\varepsilon$ the number of 1's in a row or column of a block w. Then, we have **q=$\gamma$·v, v=$\delta$·w** and **w=$\varepsilon$·1.** The above described subdivisions are applied to the entire matrix **H** meaning that the subdivision sizes **q, v** and **w** of all 3 Levels are constant for the entire matrix **H.**

Aiming at a simplified implementation of the specific 3-level representation of matrices **H,** we constraint the size of the final third level **w** to be constant. For our implementation example, we set **w=$\varepsilon$=4.** This constraint is offering a significant advantage in the encoding process since operations can be performed in blocks of input data of size equal to w. This is an important benefit compared to other decomposition based on only 2 levels since the additional Level-3 offers the possibility to encode larger number of information bits (due to larger size sparse matrices) performing an equivalent number of encoding operations in parallel.

For the usage of different codeword lengths, we constraint $\gamma$ to be fixed and modify only the size $\delta$ following a specific methodology described in the following paragraphs. For our implementation example we set $\gamma$**=21.**

For each non-zero block (named in this paragraph higher block) of any of the three levels of representation of **H,** the non-zero blocks or elements (named here as lower blocks or elements) of the level underneath it are following a quasi-cyclic representation based on right cyclically shifting the non-zero lower blocks or elements positioned in the diagonal of the higher block as shown in **Figure 2**. This corresponds to the determination circulant matrices that are formed from cyclic permutation of a diagonal matrix. This implies that only one non-zero lower block or element is placed per row and column of the higher block. In addition, only one value, namely the shift value, is needed, as we will describe below, to determine the position of all non-zero lower blocks within a higher block. Hence, for Level-1 blocks of size $q$, we denote by $b$ the number of $r$ blocks or of Level-2 required for right shifting the diagonal r-Elements of size $r$ within the $q$ block. For consistency, if $b$ is zero, there are no non-zero r-Elements in Level-1 block. Therefore, $b$ can take integer values from $0$ to $\gamma$. Similarly, we denote by $z$ the right shift value of Level-2 of $u$ blocks or u-Elements. The shift value $z$ can take integer values from $0$ to $\delta$. Following the same notation, we denote by $t$ the shift of Level-3 blocks taking values from $0$ to $\varepsilon$. We notice that since the same cyclic representation is applied to all defined Levels, each block of any Level has only one non-zero value in each of its row or column. We can also notice that if a block of any of the three levels of representation has a non-zero shift value than there exist blocks of any level belonging or underneath this block that must contain non-zero shift values.

Hence, following our implementation example, the values supported are $b \in [0; 21]$ with the value $0$ meaning that all elements of block $q$ are zero blocks. The value $1$ corresponds to have non-zero Level-2 $r$ blocks that follow the diagonal within the Level-1 $q$ block. Since we have set $w=4$, the shift value $t$ belongs to the interval [0; 4]. As we will see in the following paragraphs, the size of Level-2 is modifiable to make possible the support of different codeword lengths. In our example as we will show below the values of $z \in [0; 8]$.

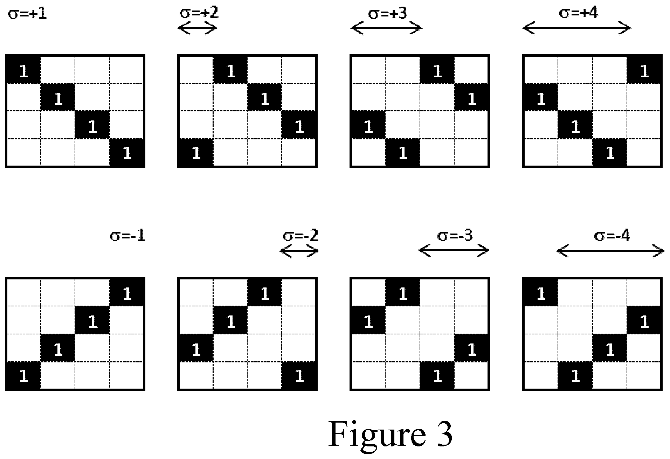

As described before, we consider the implementation of predetermined circular permutations applied over the rows of square matrices of any Level of matrix **H** based on a shift value. Hence, we can consider a square matrix block of size $i$ (which can be either $q$, $v$ or $w$ block) composed of square elements $e$ and $\sigma \in [1; i]$ the right shift value identifying circular permutation applied to the diagonal elements $e$ of the block. Then an element $e$ of the block $i$ that is identified by the position $(x, y)$ with its column position $x \in [1; i]$ and its row position $y \in [1; i]$ is non-zero if the condition $x=mod_i[(y-1)+(\sigma-1)]+1$ is satisfied given that $mod_i[.]$ defines the modulo-i operation. We further extend the circular permutation in rectangular blocks of matrix **H** by considering the application of left shifts of the anti-diagonal matrix which is defined as the matrix with its non-zero elements placed in the diagonal going from the lower left corner to the upper right corner. Hence, we can assume a square matrix block of size $i$ (which can be either $q$, $v$ or $w$ block) composed of square elements $e$ and $\sigma \in [-1; -i]$ the left shift value identifying circular permutation applied to the anti-diagonal elements $e$ of the block. Then, an element $e$ of the block identified by the position $(x, y)$ with its column position $x \in [1; i]$ and its row position $y \in [1; i]$ is non-zero if the condition $x=mod_i[-y+(\sigma+1)]+1$ is satisfied. An example of such left shifts is shown in **Figure 3** for Level-3 blocks of size 4. In this case, the shift values can also take negative values. Following this extension, we can redefine the intervals of the shifts of our three levels representation of matrix **H** as $b \in [-\gamma; +\gamma]$, $z \in [-\delta; +\delta]$ and $t \in [-\varepsilon; +\varepsilon]$ considering that the value $0$ is used to identify the zero block. The main advantage of this extension with circular permutation of the anti-diagonal comes from the simple reduction of the number of girths in matrix **H**. Firstly, by doubling the possible circular representations of non-zero values in blocks, the possible combinations of blocks in matrix **H** are significantly increased which reduces the number of girths counted. Secondly, when only positive (or negative) shifts are used, the number of girths - if existing - is always equal to the size of the blocks involved in the girth computation. However, when combinations of positive and negative circular shifts are used, the number of girths is either equal to the size of the blocks involved in the girths estimation or equal to 1.

In the preferred embodiment of the invention, we impose that Level-1 shifts are only positives. Hence, in our implementation example, we still have $b \in [0; 21]$. However, Level-2 shifts become $z \in [-8; 8]$ and Level-3 shifts $t \in [-4; 4]$. In these last two cases, the value -1 corresponds to a distribution of the non-zero sub-blocks belonging to the block of Level-2 or Level-3 that follows the anti-diagonal matrix as shown in **Figure 3.**

From the above we deduce that for each block of any level only a shift value is necessary for the identification of the positions of non-zero sub-blocks. Hence, we need one $b \in [0; +\gamma]$ shift value for each of the Level-1 square blocks of matrix **H,** i.e. a total of different $\alpha \cdot \beta$ values. Since, zero Level-1 blocks of matrix **H** do not include any non-zero Level-2 blocks we consider the non-zero Level-2 shifts applied only to the non-zero Level-1 blocks of matrix **H**. Therefore, for each non-zero Level-1 block having a shift value $b \neq 0$, we need $\gamma$ values for the representation of shifts $z \in [-\delta; +\delta]-\{0\}$ of its Level-2 blocks. Hence, considering $\eta$ the number of non-zero blocks of size $q$ in the entire matrix **H,** we need a total of $\eta \cdot \gamma$ non-zero shift values. Then, for each of these non-zero Level-2 blocks, we need $\delta$ values for the representation of shifts $t \in [-\varepsilon; +\varepsilon]-\{0\}$ of its Level-3 blocks. This gives a total of $\eta \cdot \gamma \cdot \delta$ non-zero shift values. Hence, in total, a matrix **H** is represented by $\alpha \cdot \beta + \eta \cdot \gamma + \eta \cdot \gamma \cdot \delta = \alpha \cdot \beta + \eta \cdot \gamma (1+\delta)$ shift values. We can reduce this total number of shift values required for the representation and storage of all non-zero elements of the entire matrix **H** by imposing, in this invention, a constraint in the shift values of Level-3 blocks. We constraint to all non-zero Level-3 u-Elements of a Level-2 r-Element having a shift value $z$ to have the same shift value $t$ with a sign equal to the sign of shift value $z$. In this case, we can define a common shift value s that integrates the shifts of both Level-2 and Level-3 blocks. The shift value $s$ can be obtain from $z$ and $t$ through the equation $s=sign(z) \cdot \varepsilon \cdot (|z|-1)+sign(z) \cdot |t|$ with $sign(.)$ being the sign operation and $|.|$ being the absolute operation. We have $s \in [-\delta \cdot \varepsilon; +\delta \cdot \varepsilon]-\{0\}$. With this shift numbers restriction, only one shift value is needed for the identification of non-zero elements in a Level-2 block and its corresponding Level-3 blocks. Hence, the entire matrix **H** can be represented by a total of $\alpha \cdot \beta + \eta \cdot \gamma$ shift values. Notice that the shift values $z$ and $t$ can be obtained from shift value $s$ using the

$$z = sign(s) \cdot \left[ floor\left( \frac{|s|-1}{\varepsilon} \right) + 1 \right]$$

$$t = sign(s) \cdot \left[ rem\left( \frac{|s|-1}{\varepsilon} \right) + 1 \right]$$

following equations, with $sign(.)$ being the sign operation, $|.|$ being the absolute operation, floor$(.)$ being the floor operation of a real number, i.e. the larger integer not greater than the real number and rem$(.)$ being the remainder operation of the division of two integers.

Following our implementation example, under the above mentioned constraints and having set $\delta=8$ and $\varepsilon=4$, we have $s \in [-32; 32]$. Hence, as an example, in order to get the common shift value s from the shift values $z=-5$ and $t=-3$, we apply $s=sign(-5) \cdot 4 \cdot (|-5|-1) + sign(-5) \cdot |-3| = (-1) \cdot 4 \cdot 4 + (-1) \cdot 3 = -19$. Notice that $z$ and $t$ must have the same sign, i.e. be both cyclic shifts of either diagonals or anti-diagonals matrices. In order to restore the shift values z and t from the shift value $s=-19$, we apply

$$z = sign(-19) \cdot \left[ floor\left( \frac{|-19|-1}{4} \right) + 1 \right] = (-1) \cdot \left[ floor\left( \frac{18}{4} \right) + 1 \right] = (-1) \cdot [4+1] = -5$$

$$t = sign(-19) \cdot \left[ rem\left( \frac{|19|-1}{4} \right) + 1 \right] = (-1) \cdot \left[ rem\left( \frac{18}{4} \right) + 1 \right] = (-1) \cdot [2+1] = -3$$

Since we have fixed sizes $\gamma$ and $\varepsilon$ for Level-1 and Level-3 blocks respectively, we constraint the size $\delta$ of Level-2 blocks to belong to a constraint set of positive integers A. In fact, we constrain all non-zeros Level-2 rectangular blocks of matrix **H** to have dimensions equal to $v=n \cdot \varepsilon = n \cdot w$ with **n** being a value from a constraint set $\Delta$ of positive integers. Hence, for each value of **n**, all Level-2 blocks of **H** will be of the same size $v=n \cdot \varepsilon = n \cdot w$ defining a partitioning into blocks of matrix **H**. All different values of the set $\Delta$ serve to define a family of matrices **H** of different sizes that can be used for the encoding of different codeword lengths. We set an additional constraint on the values $n \in \Delta$ to be on the form $n=2^N$ with $N \in [0; K-1]$ with **K** being a predetermined positive integer determining the number of different codeword lengths supported by the LDPC encoder and decoder. Hence, for example, if **w=4** and **K=4,** then **N={0, 1, 2, 3}**, $\Delta$**={1, 2, 4, 8}** and **v={4, 8, 16, 32}**. Following the above mentioned constraint, it becomes possible to re-dimension Level-2 block $v_n=2^n \cdot w$ to block $v_{n-1}=2^{n-1} \cdot w$ by reducing the number of rows and columns of the Level-2 block to half. This re-dimensioning method can be repeated starting from $v_{K-1}=2^{K-1} \cdot w$ until $v=w$. We notice that since parameters $\beta$, $\gamma$, and $\varepsilon$ are fixed, the set $\Delta$ is defining different horizontal dimensions of a family of matrices **H and** parameter **K** can be used for the characterization of the horizontal dimensions of this family of matrices. Hence, parameter **K** is giving the number and the sizes of the different codeword lengths supported by the system.

Having determined a methodology to modify the size of Level-2 blocks, we need to determine a methodology to convert the shift values applies to Level-2 block with a higher power of 2 to shift values for Level-2 block of a lowest power of 2. Hence, assuming that $z_n$ is the shift value determined to Level-2 block $v_n$ then the shift value $z_{n-1}$ of the re-

$$z_{n-1} = sign(z_n) \cdot \left[ floor\left( \frac{|z_n|-1}{2} \right) + 1 \right]$$

dimensioned Level-2 block $v_{n-1}$ is obtained from the equation

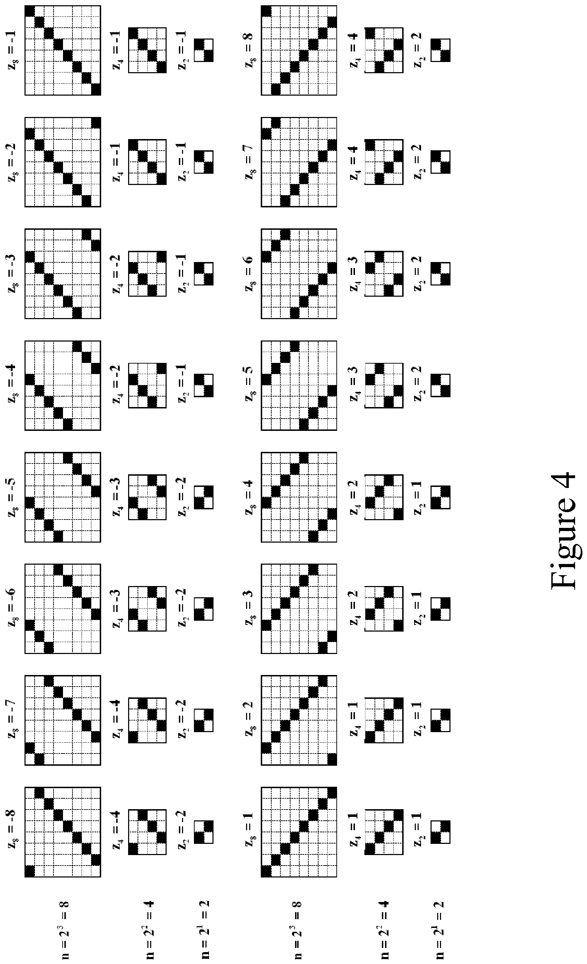

An example of the re-dimensioning of Level-2 blocks and the operations to obtain the equivalent shift values is shown in **Figure 4** assuming that **K=4.** In that case, we have $N \in$ **{0, 1, 2, 3}** and $\Delta \in$ **{1, 2, 4, 8}**. Then, for Level-2 size $v_8$**=8,** we have shift values $z_8$**={-8, -7, -6, -5, -4, -3, -2, -1, 1, 2, 3, 4, 5, 6, 7, 8}**. The equivalent shift values for $v_4$**=4** are given by $z_4$**={-4, -4, -3, -3, -2, -2, -1, -1, 1, 1, 2, 2, 3, 3, 4, 4}**. After further re-dimensioning of Level-2 blocks to $v_2$**=2,** we obtain the equivalent shift values $z_2$**={-2, -2, -2, -2, -1, -1, -1, -1, 1, 1, 1, 1, 2, 2, 2, 2}**.

We notice that the re-dimensioning transformation function of the shift values described above is not bijective meaning that we can obtain shift value $z_{n-1}$ from shift value $z_n$ but we cannot perform the inverse operation, i.e. obtain shift value $z_n$ from shift value $z_{n-1}$. This implies that the shift values used for all families of matrices **H** and the set of possible codeword lengths given by the values within $\Delta$ can be determined by the shift values defined for the maximum supported codeword length identified by the value of **K.** Hence, with the above methodology of characterization of the set of families of matrices **H** of different codeword lengths, we need to determine and store only the shift values corresponding to the highest power of 2 in set $\Delta$, i.e. those corresponding to the value of **K.** The shift values for **K,** its sparse matrix and the rectangular blocks of Level-1 composing it can be identified as master shift values, master matrix and master rectangular blocks from which other shift values, sparse matrices and rectangular blocks can be obtained for lower codeword lengths.

For our implementation example, we have Level-2 block sizes $\delta \in$ **{1, 2, 4, 8}** that define a set of family of matrices **H** and can be used to determine the different codeword lengths supported by the system given **by** $\beta \cdot q = \beta \cdot \gamma \cdot \delta \cdot \varepsilon$**.** It is possible to store the corresponding Level-2 shift values **z** and Level-1 shift values **t** (or simply their combined shift value s) for each different value $\delta$**.** However, thanks to the formulation of $\delta$ as a power of 2 and the transformation function previously defined for the computation of shift values after re-dimensioning of Level-2 blocks, only the shift values corresponding to the highest power of 2 are needed for storage. In fact, we can exploit the binary signed representation of an integer value so simplify the implementation of operations such as sign, floor, absolute value, remainder and division or multiplication by 2. Hence, for example, the shift value **s=-19** corresponding to shift values **z=-5** and **t=-3** can be represented by 1 bit for the sign and 5 bits for its absolute value giving **'110011'.** We notice that **'10011'** can be split into two parts the first 3 bits **'100'** which is a value equal to Level-2 shift value **|z|-1=5-1=4** and the next 2 bits **'11'** which is a value equal to Level-3 shift value **|t|-1=3-1.** For the re-dimensioned Level-2 block the new shift value is given by performing a division by 2 of the previously-shift value z, i.e. by taking only the left 2 bits out of the 3 bits which gives **'10'** a binary value equal to 2. Hence, the new shift value for the re-dimensioned Level-2 block is **'11011'** which give a new **|z|=2+1=3.** This defines the new shift value **s=-11.** We notice that this binary transformation correspond to the

$$-3 = sign\left(-5\right)\cdot\left[\,floor\left(\frac{|-5|-1}{2}\right)+1\right]=\left(-1\right)\cdot\left[2+1\right]$$

equation                                                                                                                          . The above binary operations on shift values can be carried out for all different values of $\delta$ i.e. different codeword lengths. Therefore, we need to store only the shift values for the highest possible value of $\delta$ that in our example is equal to **8.** This means that from the shift values **s**$\in$**[-32, 32]** we can recover the shift values for all different codeword lengths and determine a different matrix **H** of a family of sparse parity matrices with variable codeword lengths. An additional advantage of this operation is that certain properties of the matrices such as the number of girths of matrix **H** remain unchanged for all matrices of the family of matrices. Optimization on the selection of the shift values can be performed for a unique matrix **H** of the family of sparse parity matrices for different codeword lengths.

In particular for sub-matrices **B**, **D**, **E** and **T,** we select to restrain Level-3 non-zero blocks of size $w$ to support only diagonal values, i.e. **t=1.** This has a direct implication that all shift values **s-1** are divisible by the Level-3 size $\varepsilon$ but also that Level-2 shift values z take only positive values since both **z** and **t** must have the same sign. As an example and considering the shift values **s**$\in$**[-32, 32]** we have for sub-matrices **B**, **D**, **E** and **T,** the definition of a subset of these shift values given by shift values **z**$\in$**[1; 8]** and **t=1,** i.e. the subset of shift values **s**$\in$**{1, 5, 9, 13, 17, 21, 25, 29}.**

In a more general way, we can determine an integer value **L** satisfying the condition **L=2**$^M$ with **M**$\in$**[0, K-2].** We can then use the value **L** to select a subset of the Level-2 positive shift values of z given for the maximum Level-2 size $\delta$**=2**$^{K-1}$**,** by taking those positive shift values z-**1** that are divisible by value **L.** Hence, for example, in **Figure 4,** we have considered the maximum Level-2 size to be **n=2**$^3$**=8** which implies that **K=4.** This provides the positive shift values **z**$_8$**={1, 2, 3, 4, 5, 6, 7, 8}.** We can than define a integer value **L=2** and determine the subset of values **z**$_8$ such as each **z**$_8$**-1** value is divisible by **L=2** which gives the new subset **z**$_8$**={1, 3, 5, 7}.** Similarly, if we consider the integer value **L=4** we get the subset **z**$_8$**={1, 5}.** We notice that the integer value **L** is splitting the **2**$^{K-1}$ by **2**$^{K-1}$ Level-2 block into sub-blocks of size **L** by **L** that are either zero or have non-zero elements in its diagonal. However, since the size of Level-2 blocks **v**$_n$**=2**$^n$ is given as a power of 2 and value **L=2**$^M$ is also given as a power of 2, the selection operation of shift values z for **2**$^{K-1}$ by **2**$^{K-1}$ Level-2 blocks based on **L** determines those shift values z that can be obtained through a bijective operation for Level-2 blocks given for the cases **n=K-1-M** up to **n=K-1.** In fact, the value **L** serves to determine a subset of shift values z for which a re-dimensioning method can be applied to a Level-2 block of size **n-1** to a Level-2 block of size **n.** The operation to determine the shift value **z**$_n$ from shift value **z**$_{n-1}$ is given by the equation- **z**$_n$ **= 2·(z**$_{n-1}$ **-1) + 1** . This re-dimensioning method corresponds to replace each element of a Level-2 block defined for a size given for **n-1** by a 2-by-2 element that is either the zero matrix or the diagonal matrix depending if the element of a Level-2 block which size is given for **n-1** is either 0 or 1 respectively. This re-dimensions the Level-2 blocks **v**$_{n-1}$**=2**$^{n-1}$ to a Level-2 blocks **v**$_n$**=2**$^n$**.** Hence, from **Figure 4,** we notice that if **L=2,** given **z**$_4$**={1, 2, 3, 4}** we can deduce **z**$_8$**={1, 3, 5, 7}** and this operation is valid for **n=K-1-M=4-1-1=2** up to **n=K-1=4-1=3.** Notice that the above constraints maintain the characterization of shift values of a matrix of any value of $\delta$ by the shift values assigned for the highest Level-2 size $\delta$**=2**$^{K-1}$**.**

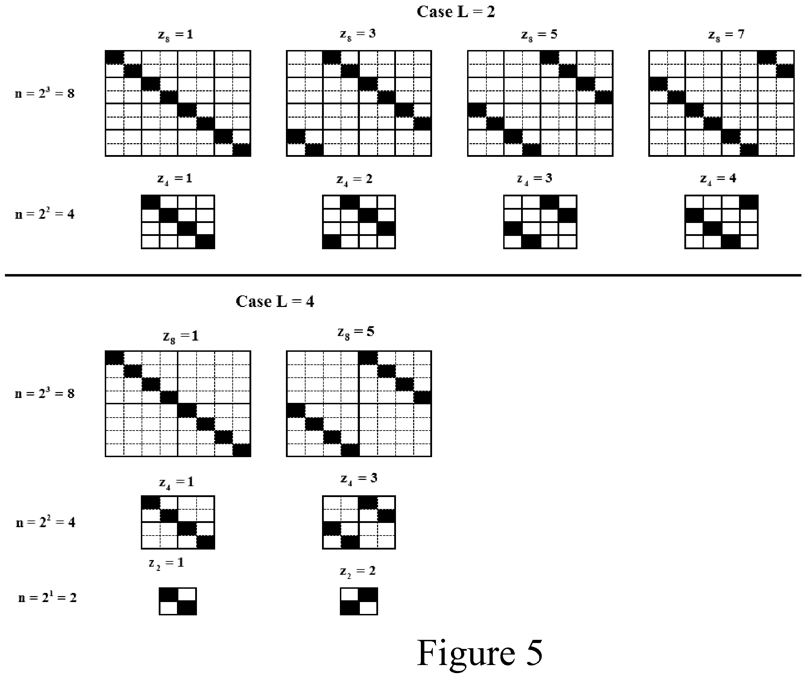

In our implementation example, we are considering both cases where **L=2** and **L=4** that are shown in **Figure 5.** This means that for sub-matrices **B**, **D**, **E** and **T** and from the positive shift values **z={1, 2, 3, 4, 5, 6, 7, 8}** we maintain the subset of shift values **z={1, 3, 5, 7}** when **L=2.** As **t =1,** we then have **s={1, 9, 17, 25}.** When **L=4,** then **z={1, 5}** and

**s={1, 17}.** It is obvious that it is preferable to have a selection subset of shift values z under the above mentioned constraint as large as possible to maximize the diversity of Level-2 shift values in sub-matrices B, **D, E** and **T.** The additional selection of **L=4** is based on requirements for the support of operations for the case **n=2** and will be further analyzed below.

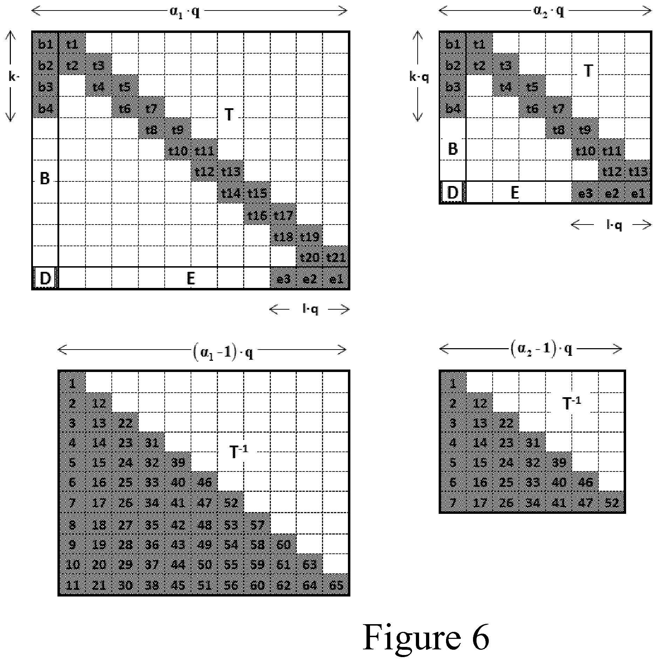

This constraint is particularly useful for matrix **T** in which we impose that all Level-1 shift values **b** are set to the value of *1,* i.e. non-zero Level-2 blocks of a non-zero Level-1 block of matrix **T** are those positioned on the diagonal of the Level-1 block. In this case, matrix **T$^{-1}$** is a lower triangular matrix with all non-zero Level-1 blocks having a shift values **b** equal to *1* as shown in **Figure 6.** From the above mentioned constraints, matrix **T** can be subdivided into blocks of a power of 2 of $\varepsilon$ which are either zeros or diagonals. The product and sum of these blocks is either a zero block or a diagonal block of size the same power of 2 of $\varepsilon$ in modulo-2 arithmetic. This condition serves to satisfy the condition that **T·T$^{-1}$** is equal to the identity matrix and impose that matrix **T$^{-1}$** can also be subdivided into blocks of size a power of 2 of $\varepsilon$ which are either zeros or diagonals. Therefore, it becomes possible to recover and represent matrix **T$^{-1}$** with Level-2 shift values that belong to the subset of possible Level-2 shift values of matrix T determined by the power of 2 given by **L.**

This particular point is extremely important since multiplication with matrix **T$^{-1}$** is used in several steps of the encoding process as we will see below. By constraining matrix **T** to be composed only of diagonal non-zero rectangular blocks of a power of 2 of $\varepsilon$, the rectangular non-zero blocks of the same power of 2 of $\varepsilon$ of **T$^{-1}$** are also diagonals. Therefore, for our implementation example, Level-2 shift values of blocks of **T$^{-1}$** belong also to **s={1, 9, 17, 25}** or **s={1, 17}** under the conditions determined above.

Finally, as mentioned above, the code rate of LDPC can be modified by modifying the value $\alpha$ of Level-1 columns from matrix **H.** We can determine a methodology to deduce the sub-matrices **B, D, E,** and **T** of a specific rate from the sub-matrices **B, D, E,** and **T** given for the minimum possible rate determined by the maximum value of $\alpha$. The maximum rate possible is obtained by the **max(k, l)** where **k** and **l** are the corresponding non-zero Level-1 **q** elements from matrices **B** and **E** respectively. The construction of new sub-matrices **B, D, E,** and **T** for a specific code rate is achieved by removing the bottom zero **j** Level-1 **q** blocks from matrices **T** and **B.** The same **number j** of columns of Level-1 blocks **q** is removed from the right of **T** and from the left **of E.** Matrix **D** is not modified.

The newly obtained sub-matrices **B, D, E,** and **T** are then combined in the right of matrix **H** assuring that l non-zeros Level-1 blocks are still present in matrix **E.**

The removal of the bottom rows and right columns of Level-1 blocks q of **T** is equivalent to the removal of the bottom rows and right columns Level-1 blocks **q** of **T$^{-1}$** and the condition where **T·T$^{-1}$** is equal to the identity matrix is satisfied. This is valid if the constraints previously described for **T** and **T$^{-1}$** are maintained. An example of such transformation is shown in **Figure 5** for a transformation from $\alpha_1$**=12** to $\alpha_2$**=8.** In this example, 4 zero Level-1 blocks of matrix **B** and for zero Level-1 blocks of matrix **E** are removed. Also, the bottom 4 rows and the 4 right columns of matrices **T** and **T$^{-1}$** are removed.

This last methodology is useful for the storage of only one set of matrices **B, D, E** and **T$^{-1}$** for all possible code rates supported for the system. In our implementation example since the maximum value of $\alpha$**=12,** we can store only the corresponding shift values of matrices **B, D, E** and **T$^{-1}$** for this rate and deduce the corresponding shift values of all other rates by taking subset of these shift values following the above mentioned methodology. Since the number of non-zero Level-1 blocks in **B** and **E** is 2 and 1 respectively, the minimum value **of** $\alpha$**=3** (due to **max(2, 1)=2** and the addition of matrix **D).**

Having decided the rates $\alpha$ supported by the system, different set of shift values for matrices **A** and **C** must be stored for all rates implemented. From the set of values of $\alpha$ and knowing that $\beta$ is fixed, the sizes of matrices **A** and **C** for all rates implemented can be deduced.

## *Encoder*

In general, the encoding operation in LDPC codes, in order to obtain codeword $\overline{c}$, is performed using the generator matrix **G** following the equation $\overline{c} = \overline{x} \cdot \mathbf{G}$ with $\overline{x}$ being the information bit sequence, i.e. the block of data, to encode. However, the generator matrix **G** obtained from the sparse parity-check matrix **H** is usually dense and cannot be represented by cyclic permutations of blocks. To reduce storage and computation requirements, encoding can be performed by using the decomposition **of H** into sub-matrices and perform multiplications mainly with sparse sub-matrices of **H.** Hence, the computation of codeword $\overline{c}$ is obtained from the systematic part $\overline{x}$ and the computation of parity bits $\overline{p}_1$ and $\overline{p}_2$ with $\overline{p}_1$ of length **q,** and $\overline{p}_2$ of length **($\alpha$-1)·q.**

The parity bits $\overline{p}_1$ and $\overline{p}_2$ are derived from the information bits $\overline{x}$ following the relationships:

$$\bar{p}_1^T = \left( D + E \cdot T^{-1} \cdot B \right)^{-1} \cdot \left( C + E \cdot T^{-1} \cdot A \right) \cdot \bar{x}^T = \varphi^{-1} \cdot \left( C + E \cdot T^{-1} \cdot A \right) \cdot \bar{x}^T$$

with

$$\varphi = D + E \cdot T^{-1} \cdot B \text{ and } \bar{p}_2^T = \left( A \cdot T^{-1} \right) \cdot \bar{x}^T + \left( T^{-1} \cdot B \right) \cdot \bar{p}_1^T = T^{-1} \cdot \left[ A \cdot \bar{x}^T + B \cdot \bar{p}_1^T \right]$$

Using the block representation of **H**, we have:

$$H \cdot \bar{c}^T = \begin{bmatrix} A & B & T \\ C & D & E \end{bmatrix} \cdot \begin{bmatrix} \bar{x}^T \\ \bar{p}_1^T \\ \bar{p}_2^T \end{bmatrix} = \begin{bmatrix} A \cdot \bar{x}^T + B \cdot \bar{p}_1^T + T \cdot \bar{p}_2^T \\ C \cdot \bar{x}^T + D \cdot \bar{p}_1^T + E \cdot \bar{p}_2^T \end{bmatrix}$$

By replacing with the above mentioned values of $\bar{p}_1$ and $\bar{p}_2$, we get:

$$H \cdot \bar{c}^T = \begin{bmatrix} A \cdot \bar{x}^T + B \cdot \bar{p}_1^T + T \cdot T^{-1} \cdot \left[ A \cdot x^T + B \cdot \bar{p}_1^T \right] \\ C \cdot \bar{x}^T + D \cdot \bar{p}_1^T + E \cdot T^{-1} \cdot \left[ A \cdot x^T + B \cdot \bar{p}_1^T \right] \end{bmatrix} =$$

$$= \begin{bmatrix} A \cdot \bar{x}^T + B \cdot \bar{p}_1^T + \left[ A \cdot \bar{x}^T + B \cdot \bar{p}_1^T \right] \\ C \cdot \bar{x}^T + D \cdot \bar{p}_1^T + E \cdot T^{-1} \cdot \left[ A \cdot \bar{x}^T + B \cdot \bar{p}_1^T \right] \end{bmatrix} =$$

$$= \begin{bmatrix} 2 \cdot A \cdot x^T + 2 \cdot B \cdot \bar{p}_1^T \\ C \cdot \bar{x}^T + D \cdot \bar{p}_1^T + E \cdot T^{-1} \cdot A \cdot \bar{x}^T + E \cdot T^{-1} \cdot B \cdot \bar{p}_1^T \end{bmatrix} =$$

$$= \begin{bmatrix} 0 \\ \left( C + E \cdot T^{-1} \cdot A \right) \cdot \bar{x}^T + \left( D + E \cdot T^{-1} \cdot B \right) \cdot \bar{p}_1^T \end{bmatrix} =$$

$$= \begin{bmatrix} 0 \\ \left( C + E \cdot T^{-1} \cdot A \right) \cdot \bar{x}^T + \left( D + E \cdot T^{-1} \cdot B \right) \cdot \left( D + E \cdot T^{-1} \cdot B \right)^{-1} \left( C + E \cdot T^{-1} \cdot A \right) \cdot \bar{x}^T \end{bmatrix} =$$

$$= \begin{bmatrix} 0 \\ 2 \cdot \left( C + E \cdot T^{-1} \cdot A \right) \cdot \bar{x}^T \end{bmatrix} = \begin{bmatrix} 0 \\ 0 \end{bmatrix} = 0$$

Hence, using the relationships defined above for parity bits $\bar{p}_1$ and $\bar{p}_2$ we can obtain the equivalent codeword $\bar{c}$ from the information block of data $\bar{x}$.

The computation of the two parity check bits can be decomposed in the following steps:

**Step A1:** $$\bar{p}_{A1} = A \cdot \bar{x}^T$$

**Step A2:** $$\bar{p}_{A2} = T^{-1} \cdot \bar{p}_{A1} = T^{-1} \cdot A \cdot \bar{x}^T$$

**Step A3:** $$\bar{p}_{A3} = E \cdot \bar{p}_{A2} = E \cdot T^{-1} \cdot A \cdot \bar{x}^T$$

**Step A4:** $$\bar{p}_{A4} = C \cdot \bar{x}^T$$

**Step A5:** $$\bar{p}_{A5} = \bar{p}_{A4} + \bar{p}_{A3} = \left( C \cdot \bar{x}^T \right) + \left( E \cdot \left( T^{-1} \cdot \left( A \cdot \bar{x}^T \right) \right) \right)$$

(continued)

**Step A6:**
$$\overline{p}_1^T = \overline{p}_{A6} = \varphi^{-1} \cdot \overline{p}_{A5} = \varphi^{-1} \cdot \left[ \left( C \cdot \overline{x}^T \right) + \left( E \cdot \left( T^{-1} \cdot \left( A \cdot \overline{x}^T \right) \right) \right) \right]$$

**Step B1:**
$$\overline{p}_{B1} = A \cdot \overline{x}^T = \overline{p}_{A1}$$

**Step B2:**
$$\overline{p}_{B2} = B \cdot \left\{ \varphi^{-1} \cdot \left[ \left( C \cdot \overline{x}^T \right) + \left( E \cdot \left( T^{-1} \cdot \left( A \cdot \overline{x}^T \right) \right) \right) \right] \right\} = B \cdot \overline{p}_{A6} = B \cdot \overline{p}_1^T$$

**Step B3:**
$$\overline{p}_{B3} = \overline{p}_{B1} + \overline{p}_{B2} = A \cdot \overline{x}^T + B \cdot \left\{ \varphi^{-1} \cdot \left[ \left( C \cdot \overline{x}^T \right) + \left( E \cdot \left( T^{-1} \cdot \left( A \cdot \overline{x}^T \right) \right) \right) \right] \right\}$$

**Step B4:**
$$\overline{p}_2^T = \overline{p}_{B4} = T^{-1} \cdot \overline{p}_{B3} = T^{-1} \cdot \left\{ A \cdot \overline{x}^T + B \cdot \left\{ \varphi^{-1} \cdot \left[ \left( C \cdot \overline{x}^T \right) + \left( E \cdot \left( T^{-1} \cdot \left( A \cdot \overline{x}^T \right) \right) \right) \right] \right\} \right\}$$

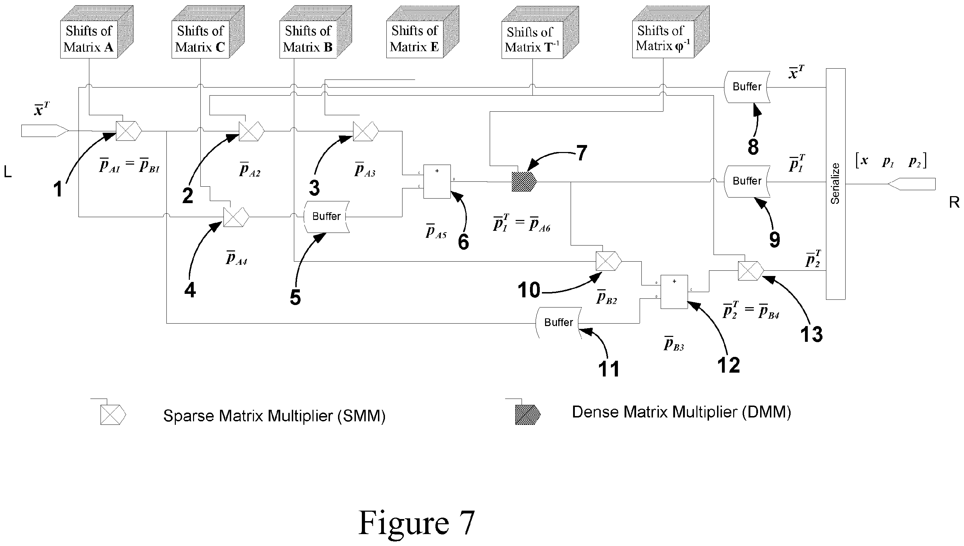

The schematic of the encoding process described above is described in **Figure 7.** Encoding operations are formed by a certain number of vector multiplication with a sparse matrix that according to the decomposition of **H** can be represented by a certain number of cyclic shift values, a couple of vector additions, certain buffering operations and a vector multiplication with a dense matrix that is required in **Step A6** only. We define by Sparse Matrix Multiplier (SMM) **1, 2, 4, 10, 13** the component that produces vector multiplication with a sparse matrix that can be represented by cyclic shift values as described in the above section. We define by Dense Matrix Multiplier (DMM) **6** the component that produces vector multiplication with a matrix that cannot be represented with cyclic shift values. We notice that Step **A1** and Step **B1** are identical and hence can be combined into a unique step under the condition of implementing a buffer since Step **B3** requires the output from Step **B2** which can be only completed after Step **A6**. In total, we require 4 different buffering operations for the completion of the encoding process. Additionally, there are 6 different matrix multiplications with sparse matrices, i.e. 6 SMM components, 2 vector additions and only 1 matrix multiplication with a dense matrix $\phi^{-1}$, i.e. only one DMM component.

The advantage of the decomposition of matrix **H** into sub-matrices lies in the fact that dense matrix multiplication is required only for a relatively small matrix of size equal to *q*. All remaining matrix multiplications are performed over sparse matrices which positions of 1's can be determined by shift values and cyclic permutations of block elements. Due to this structure of sparse matrices, optimization of the operations of the SMM component can be achieved. Below, we will demonstrate how with the above mentioned constraints on the definition of matrices **H** of variable codeword lengths and variable code rates can be implemented with a method and apparatus in accordance with the invention.

As mentioned, there are two distinct matrix multiplication components implemented in this invention: a sparse multiplication component called Sparse Matrix Multiplier (SMM) that is working on sparse matrices which non-zero values can be determined by cyclic permutation shift values and a dense multiplication component called Dense Matrix Multiplier (DMM) that works with a compressed form of the matrix to generate outputs of variable lengths according to the codeword length configuration.

In fact all encoding Steps, beside **Step A6,** are performed by multiplication of vector by a sparse matrix that can be represented by shift values. For all Steps of the encoding process, only matrices **A, C, T⁻¹, E,** and **B** are needed. Hence only the shift values of these matrices are stored for the encoding process and not the shift values of the entire matrix **H.** In particular, shift values of matrices **D** and **T** are not needed and therefore are not stored. In addition, as we have seen we can compute the shift values of smaller codeword lengths from the shift values of the highest codeword length for a given **K**. Hence, only the shift values of the highest codeword length are stored. We have also shown that for different code rates, i.e. values of $\alpha$, the equivalent matrices **T⁻¹**, E, and **B** can be obtained from the highest value of $\alpha$. Hence, for these matrices only one set of shift values for the highest value of $\alpha$ need to be stored. Different sets of shift values must be stored for different code rates only for matrices **A** and **C.** Hence, Sparse Matrix Multiplier (SMM) components of the encoding process are provided with the corresponding shift values of matrices **A** and **C** for the targeted rate and, shift values of **T⁻¹, E,** and **B** determined for the maximum value of $\alpha$ from which they deduce the subset of shift values to use based on the targeted rate. As we, will see, the Sparse Matrix Multiplier (SMM) components are processing these shift values by computing the shift values corresponding to the codeword length targeted.

***Sparse Matrix Multiplier (SMM)***

The encoding process for sparse matrices is performed by the Sparse Matrix Multiplier (SMM) **1, 2, 4, 10, 13** that is composed of parallelized components that process Level-1 blocks of each **q** row of the sparse matrix in parallel.

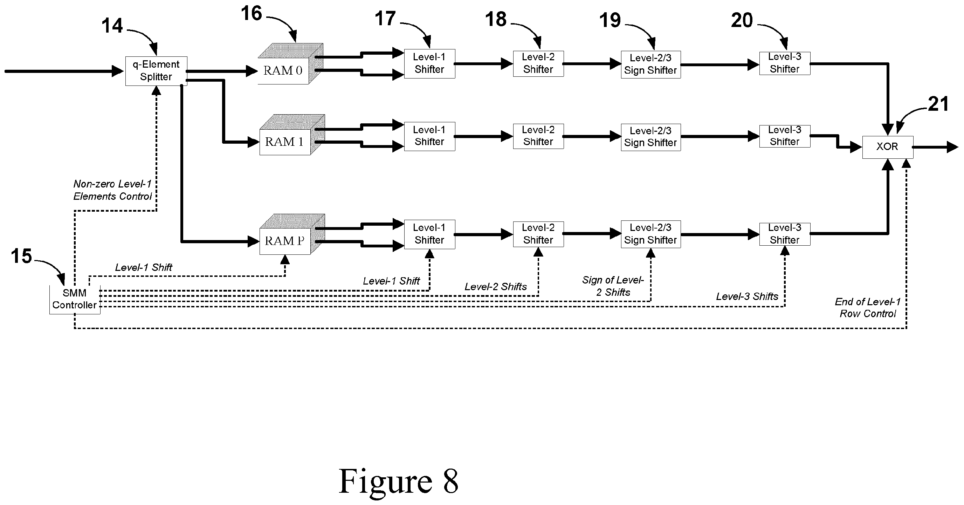

The parallelized components are composed of chains of components **16, 17, 18, 19, 20** each one formed of cascaded processors. Similar SMM entities or the same SMM entity can be used for all Steps of the encoding process described above given that no Step need to be performed in parallel with another. The SMM entity is provide with a different sparse matrix, i.e. the shift values of a different sparse matrix and the corresponding input vector for multiplication with this sparse matrix. The controller entity **15** of the SMM component is linked to each component **16, 17, 18, 19, 20** of the chains of components to provide the corresponding shift values. The diagram of the SMM entity **1, 2, 3, 4, 10, 13** is given in **Figure 8**. The processing operations of the SMM are performed in parallel by **P** parallelized encoding chains of components **16, 17, 18, 19, 20** with each chain performing the multiplication for a Level-1 block within a Level-1 $q$ row of the sparse matrix. The process of the **P** chains is repeated until all multiplication processes corresponding to the non-zero Level-1 blocks of a $q$ row are executed and then until all $q$ rows of the multiplier sparse matrix are completed. This implies that the SMM entity is operating over Level-1 rows of size $q$ and therefore sizes of the sparse matrix can be supported. The SMM entity is repeating its process independently for each Level-1 row of the sparse matrix. This implies that processing can be carried out for sparse matrices of different number of Level-1 rows and therefore different code rates can be supported since the number of Level-1 rows given by $\alpha$ is determining the rate of the LDPC encoder. This also implies that **P** non-zero Level-1 blocks of size $q$ in a row can be processed in parallel. The components of each the **P** chains are associated sequentially to process a different non-zero Level-1 $q$ block of a column of the Level-1 $q$ row under process. If the number of non-zero Level-1 $q$ blocks in the row under process is not divisible by **P** then certain of the encoding chains **P** are configured to perform no process.

For our implementation example, let's consider that **P=2,** i.e. there are only two parallel encoding chains **16, 17, 8, 19, 20** in **Figure 8** and therefore two Level-1 $q$ blocks can be processed in parallel. We can consider the implementation of **Step A1** where we have the multiplication of the information bit sequence $\bar{x}$ with the sparse matrix A. If the first Level-1 $q$ row of matrix **A** has, for example, **13** non-zero Level-1 $q$ blocks, then the 1st and 2nd Level-1 $q$ blocks are processed by the two encoding chains in parallel, then the 3rd and 4th Level-1 $q$ blocks are processed and so on. At the end of the first Level-1 $q$ row processing, the first encoding chain is processing the 13th non-zero Level-1 $q$ block while the second encoding chain is inactive and performs no encoding process. The outputs of the inactive encoding chains are set to be a sequence of zeros. The XOR operation at the end of the SMM entity corresponds to an addition of all outputs of the **P** chains. This corresponds to the addition of all multiplication operations of the **P** chains that correspond to the **P** multiplications of input sequences with the **P** non-zero Level-1 $q$ blocks. Hence, setting the outputs of the inactive chains to all zero values is similar of performing additions of only the outputs of the active encoding chains. All the above mentioned operations are controlled by the SMM controller **15** component that contains information about the size of sparse matrix, the zero and non-zero Level-1 blocks of the sparse matrix and the shift values of all non-zero blocks of the sparse matrix.

The initial step is to assign into each of the **P** RAM memories, the input data bits that correspond to the equivalent non-zero Level-1 block of the $q$ row under process by each of the **P** chains. Therefore, the input data bits are split by q-Element splitter **14** into consecutive sequence of input bits of size $q$ namely a packet of bits. The sequence of input bits corresponding to the non-zero Level-1 block of the $q$ of the row under process by the g encoding chain is assigned to be stored in the RAM of the $g$ chain. Hence, if in the Level-1 $q$ row under process, the 1st and the 3rd Level-1 blocks are non-zero blocks, the 1st sequence of input bits are stored in RAM0 while the 3rd sequence of input bits is stored in RAM1.

The sizes of the memory elements of the **P** RAM memories including the size of the connection buses among components of the **P** chains is set to be constant and equal to the maximum size $R=v\cdot w=2^{K-1}\cdot\varepsilon$ supported by the system. Hence, the sequences of input bits of size $q$ are further subdivided into sets of sequences of size $R$ that are stored into the **P** RAM memories noticed as sequences of sets of a packet. In the case that a codeword length lower than the maximum supported by the system is selected, meaning that $v=2^N<2^{K-1}$, then the $R$ subsets are subdivided into subsets of $2^{N}\cdot\varepsilon$ defined as sets of the packets of bits. A certain number of such subsets can be left undetermined while the remaining subsets are filled with the input data bits of size $2^{N}\cdot\varepsilon$. The selection of the number of subsets left undetermined meaning that they are filled with zeros and no values of input bits depends on the number of Level-2 blocks included in a Level-1 block, i.e. depending of the value of $\gamma$. With this splitting and with $N<K-1^{-}$ it becomes possible to process in each of the **P** chains simultaneously one or more Level-2 blocks including their underlying Level-3 blocks.

In our implementation example, we have $\delta \in\{1, 2, 4, 8\}$ and $w=\varepsilon=4.$ Hence, we can set $R=8\cdot4=32.$ When codeword length with $\delta=8$ is selected, the number of input data bits of a Level-1 block are $\gamma\cdot\delta\cdot\varepsilon=21\cdot8\cdot4=21\cdot32=672.$ We then split these input bits into $21$ sets of $R=32$ input bits. When codeword length with $\delta=4$ is selected, the number of input data bits of a Level-1 block are $\gamma\cdot\delta\cdot\varepsilon=21\cdot4\cdot4=21\cdot16=336.$ We can then split these input bits into 11 sets of $R=32$ input bits in which $1$ of the 11 sets contains only on subset of $16$ input bits. The other subset of $16$ bits of the set of $R=32$ bits is undetermined and filled with zeros. In our implementation example we split these input bits into $21$ sets of $R=32$ input bits in which all of the $21$ sets contains only $16$ input bits and in each set of $32$ bits there are $16$ input bits and $16$ undetermined bits that are filled with zeros. When codeword length with $\delta=2$ is selected, the number of input data bits of a Level-1 block are $\gamma\cdot\delta\cdot\varepsilon=21\cdot2\cdot4=21\cdot8=168.$ We can then split these input bits into $6$ sets of $R=32$ input bits in which *1* of the *6* sets contains only *8* input bits and the other *24* bits of this unique set are undetermined and filled with zeros. In our implementation example, we split these input bits into *7* sets of $R=32$ input bits in which all of the *7* sets contains $3\cdot8=24$ input bits meaning that in each set of *32* bits there are *24* input bits and *8* undetermined bits that are filled with zeros. We then have $7\cdot3\cdot8=168$ input bits and $7\cdot1\cdot8=56$ undetermined bits. Finally, for codeword length with $\delta=1$, the number of input data bits of a Level-1 block are $\gamma\delta\varepsilon=21\cdot2\cdot4=21\cdot4=84$. In our implementation example, we split these input bits into *3* sets of $R=32$ input bits in which all of the *3* sets contains $7\cdot4=28$ input bits and in each set of *32* bits there are *28* input bits and *4* undetermined bits that are filled with zeros. We then have $3\cdot7\cdot4=84$ input bits and $3\cdot1\cdot4=12$ undetermined bits.

Then, the controller is providing to the RAM component the sequence in which these sets of $R=32$ bits should be provided to Level-1 Shifter **17** based on the shift value $b$ of the non-zero Level-1 $q$ block under process by the specific encoding chain $g$. The RAM component is providing two sets of $R=32$ bits, the one referenced by the controller and the immediately following set. When, the final set of $R=32$ bits is referenced, the RAM component is also providing the 1st set of $R=32$ bits. This operation is repeated until all sets of $R=32$ bits are referenced by the controller exactly once. These couple of sets of $R=32$ bits are provided to the Level-1 Shifter **17,** which is responsible to further process these data sets according to the codeword length selected. In fact, the shift value $b$ might require the recombination of subsets $2^{N\cdot}\varepsilon$ to guarantee the correct reordering of the subsets of size $2^{N\cdot}\varepsilon$ into the $R=32$ bits sets according to the cyclic shift value $b$. This task is performed by the Level-1 Shifter **17** that recombine the subsets of $2^{N\cdot}\varepsilon$ bits from the provided two sets of $R=32$ bits into a new set of $R=32$ bits.

In our implementation example and assuming that the codeword length selected is $\delta=8$ and $R=32,$ there are *21* sets of *32* input bits. Then, according to the shift value $b$ these sets are subsequently transferred to the Level-1 Shifter **17.** For example, if $b=5,$ the controller is referencing the 5th set and the couple of the 5th and 6th sets of $R=32$ are transferred to the Level-1 Shifter **17** which outputs the 5th set. Then, the controller **15** is referencing the 6th set and the couple of the 6th and 7th sets of $R=32$ are transferred to the Level-1 Shifter **17** which outputs the 6th set. This operation is repeated *21* times through referencing of all *21* sets of *32* input bits.

In the case, however, that $\delta=2$ or $\delta=1,$ the sets of $R=32$ input bits contain 3 or 7 subsets of *8* or *4* inputs bits respectively. Then, according to the shift value $b$ a new composition of a set of $R=32$ inputs bits is required. For example, for $\delta=2,$ the first $R=32$ bits set contains subsets *1, 2, 3* of *8* input bits, the second $R=32$ bits set contains subsets *4, 5, 6* of *8* input bits and the third $R=32$ bits set contains subsets *7, 8, 9* of *8* input bits. If $b=3,$ than a new $R=32$ bits set must be created from the 1st and 2nd $R=32$ bit sets having subsets *3, 4,* 5 of *8* input bits, i.e. taking subset number 3 from the 1st $R=32$ bits set and subsets numbered *4* and *5* from the 2nd $R=32$ bits subset. Then, the next $R=32$ bits set must have subsets *6, 7, 8* of *8* input bits from the 2nd and 3rd $R=32$ bits sets. This recombination of the operation is performed from the Level-1 Shifter **17** component based on the couple of $R=32$ sets provided by the RAM component. The Level-1 Shifter **17** must be aware of the shift value $b$ and the value of the codeword length selected given by $\delta$ in order to perform the correct recombination of the subsets from the $R=32$ bit sets. Notice that as mentioned before we consider that there is one undetermined *8* bits subsets in the $R=32$ bits sets in this implementation example. In general, shifters shift the values of the entries by a number of positions that is associated with the shift. The sign shifter reverses the order of the entries (flips) depending on the sign of the shift.

This methodology guarantees that storage size **R** of the data in the RAMs and that the connection buses among components is efficiently exploited by performing storage and transfers of several subsets of input bits even for the lower values of the codeword length. In addition, further parallelization is implemented when the encoding chain is working with $v\cdot w<R.$ As mentioned, the Level-1 Shifter **17** is processing several $v\cdot w$ blocks according to the ratio $R/(v\cdot w).$ The remaining components of each of the **P** encoding chains are also changed accordingly to processed several shift values following the number of subsets blocks **v.w** provided per chain at each instance.

This implies that for certain cases given for different codeword lengths such as in our implementation example for $\delta=2$ and $\delta=1,$ several Level-2 blocks are processed simultaneously. For example, for $\delta=2,$ in each set of *32* bits there are *3* subsets of *8* bits, i.e. there are input bits corresponding to 3 different Level-2 and Level-3 blocks. Hence, the controller **15** provides 3 different shift values to Level-2 Shifter **18,** Level-2/3 Sign Shifter **19** and Level-3 Shifter **20** components each one corresponding to the equivalent shift values of the Level-2 and Level-3 blocks included within the 32 bit set. Notice that since, from our design constraint the same shift value is applied to all Level-3 blocks included in a Level-2 block the shift values stored include the shift value of Level-3. This is achieved by providing the parts of the binary representation of the combined shift value s of Level-2 and Level-3 that has been described before. The binary part of the shift value $s$ corresponding to the value of shift value z is provided to the Level-2 Shifter **18,** the sign of the shift value $s$ is provided to the Level-2/3 Sign Shifter **19** while the binary part of the shift value $s$ corresponding to the value of shift value $t$ is provided to the Level-3 Shifter **20.**

The Level-2 Shifter **18** is then cyclically shifting the data bits according to the specified absolute z shift value. The Level-2/3 Sign Shifter block **19** is flipping the input data bits according to the sign of the combined shift s. The flipping operations for Level-2/3 Sign Shifter **19** components are performed over sets of bits over the sequence of bits of size **R** provided. Then, the Level-3 Shifter **20** is performing a cyclic shift of the **R** input data bits according to the *t* shift corresponding to Level-3 shift by operating in subsets of the input data bits of size **w.** The final operation is to perform a cumulative XOR of the output data bits of all encoding chains to produce the multiplied bits. This cumulative XOR is reset upon completion of all non-zero Level-1 blocks of each *q* row of the multiplication matrix. After the completion of the processing of a *q* row, this final component is removing the undetermined bits if included and issues the output bits for the multiplication of the *q* row of the sparse matrix with the input bits.

In our implementation example and assuming $\delta=2$, the Level-2 Shifter **18** is reordering (shifting) the *3* sets of *8* bits based on the absolute values of the 3 shift values **z** provided. Next, the Level-2/3 Sign Shifter **19** is flipping these sets of *8* bits according to the signs of the *3* shifts s provided. Then, for each of the 2 sets of *w=4* bits included in each set of *8* bits, cyclic shift is applied following the *3* values of the *t* shifts available. Notice that since the shifts values z, s and *t* are related as described above from our design selection, only one of these values must be provided to each components of the chain which in our case correspond to parts of the binary representation of shift s.

All the above operations correspond in fact to the multiplications required when a Level-1 *q* block of a matrix is multiplied with an input vector. In other words, in our implementation example, at each time the **R=32** outputs bits just before the XOR correspond to the multiplications of the *32, 16,* 24 or 28 rows of a Level-1 *q* block of the sparse matrix with the input vector. Upon completion of all multiplications of all sets of *32, 16,* 24 or 28 rows of a Level-1 *q* block, the **P** chains proceed to the multiplications corresponding to different non-zero Level-1 block in a *q* row of the sparse matrix. The cumulative XOR component is performing the additions corresponding to the matrix multiplication of a matrix by a vector by performing XOR operation of all sets **of R=32** received by the **P** chains at one time instance. Then, the cumulative XOR component is storing these values R=32 and repeat XOR operation for the next sets **of R=32** received by the **P** chains. This operation is repeated until all Level-2 and Level-3 blocks of the Level-1 blocks assigned to the **P** chains are completed. Then, the XOR operation is reiterated using the stored values until all non-zero Level-1 blocks of the *q* row are processed by the **P** chains. Then, the XOR component is output the output stored values after removal of the undetermined subset bits. For example, in our implementation, we can have **P=2** and in a *q* row of the sparse matrix *13* non-zero Level-1 *q* blocks. Then, according to the value $\delta$ giving the codeword length, i.e. *8, 4,* 2 or *1*, we have *21, 21, 7* or *3* sets respectively of **R=32** input bits for each Level-1 block processed by each of the **P** chains. The XOR component is going to perform a XOR operation for each of the *21, 21, 7* or *3* sets of *32* bits received from the **P** chains (XOR operation over the sets received) and store the outcome of *21, 21,* 7 or 3 sets of *32* bits. These sets of *32* bits are going to be used by the XOR component for the next *21, 21, 7* or *3* sets of *32* input bits issued by the **P** chains after processing the next Level-1 blocks. This XOR operation is repeated **ceil(13/2)=7** times, with *ceil(.)* being the operation giving the smallest following integer of a real number, since while each of the 2 encoding chains are processing the *13* non-zero blocks in pairs of 2. Finally, upon completion of the q row processing, the XOR component is output for each set of **R=32,** the corresponding *32, 16, 24* or *28* bits according to the value of $\delta$. Notice that at all times sets of *32* bits are processed by the XOR element **21** but only *32, 16,* 24 or 28 of them correspond to output multiplication data. The controller **15** is providing to the XOR component **21** a signal that identifies that all non-zero Level-1 blocks of the **q** row have been processed and the value $\delta$ for the identification of the valid output bits in the sets **of R=32.**

The Dense Matrix Multiplier (DMM) is needed only for Step A6 of the encoding process. Any device component that can perform multiplication of a binary matrix with a vector can be used for this encoding step. Since the matrices and vectors provided in Step A6 depend on the codeword length selected several such devices might be needed.

**Claims**

1.   An apparatus for encoding with Low-Density Parity Check codes comprising means to receive an information bit sequence to encode and a sparse matrix multiplier **(1, 2, 3, 4, 10, 13)** that includes

     ✓ splitter means **(14)** configured to split the information bit sequence into packets of bits of size $\gamma \cdot \delta \cdot \varepsilon$, where $\gamma$, $\delta$, $\varepsilon$ are non-zero, positive integers; and
     ✓ a chain of components **(16, 17, 18, 19, 20),** whereby the components include:

          • memory means **(16)** configured to store sets with equal number of $\delta \cdot \varepsilon$ bits, which sets form a packet;
          • four cascaded processing means **(17, 18, 19, 20)** configured to perform binary operations over the packets, and configured to base the binary operations on circulant blocks, with each circulant block being established by cyclic permutation of a diagonal or anti-diagonal matrix and defined by a single shift parameter, including

               ■ level-1 shifter means **(17)** configured to shift sets of $\delta \cdot \varepsilon$ bits within a packet followed by
               ■ level-2 shifter means **(18)** configured to shifts sets of $\varepsilon$ bits within a set of $\delta \cdot \varepsilon$ bits followed by
               ■ sign shifter means **(19)** between the level-2 shifter means **(18)** and level-3 shifter means **(20)** configured to flip sets of $\varepsilon$ bits within a set of $\delta \cdot \varepsilon$ bits followed by

**14**

▪ the level-3 shifter means **(20)** configured to shift bits within a set of ε bits whereby the level-2 shifter means **(18)** and the level-3 shifter means **(20)** are configured to base the binary operations on circulant blocks defined by the single shift parameter and the sign shifter means **(19)** is configured to base the binary operations on the sign of the single shift parameter

✓ a controller **(15)** that is configured to provide the shift parameters to the processing means **(17, 18, 20)** and the memory means **(16)**;

the encoding apparatus further including means to receive the packets after the packets have been processed by the sparse matrix multiplier and to provide a codeword that corresponds to the information bit sequence.

2. The apparatus according to claim **1,** whereby the sparse matrix multiplier **(1, 2, 3, 4, 10, 13)** includes a plurality of similar chains of components **(16, 17, 18, 19, 20)** arranged in parallel and configured for parallel processing and whereby the controller **(15)** is linked to each chain of components **(16, 17, 18, 19, 20)** that are arranged in parallel.

3. The apparatus according to claim **1 or 2,** comprising storage means configured to store shift parameters that define a master rectangular block, input means configured to obtain a unique controlling parameter and processing means configured to determine the shift parameters, which define the circulant blocks using the unique controlling parameter and the shift parameters that define the master rectangular block.

4. The apparatus according to any one of claims **1 to 3,** including means configured to receive the output from the sparse matrix multiplier and redirect it to the same sparse matrix multiplier for further shifting operations.

5. The apparatus according to any one of claims **1 to 4,** comprising a plurality of similar sparse matrix multipliers **(1, 2, 3, 4, 10, 13).**

6. The apparatus according to claim **5,** whereby at least two sparse matrix multipliers **(1, 2, 3)** are arranged in series, and configured so that the output of one **(1, 2)** of the at least two sparse matrix multipliers is provided as input to the other **(2, 3)** of the at least two sparse matrix multipliers.

7. The apparatus according to claim **5 or 6,** whereby each one of the plurality sparse matrix multipliers **(1, 2, 3, 4, 10)** is linked to a memory configured to contain the shift parameters, which define a circulant block, and configured to input the shift parameters to the controller **(15)** of the sparse matrix multiplier **(1, 2, 3, 4, 10).**

8. A method performed by a device for Low-Density Parity Check encoding of blocks of data bits comprising

✓ defining packets of bits including the data bits of size $\gamma \cdot \delta \cdot \varepsilon$ of a block, where $\gamma, \delta, \varepsilon$ are non-zero, positive integers;
✓ splitting each packet into sets with equal number of $\delta \cdot \varepsilon$ bits;
✓ providing shift parameters that define circulant block matrices, with each circulant block being established by cyclic permutation of a diagonal or anti-diagonal matrix and defined by a single shift parameter;
✓ performing consecutive shifting binary operations based on the shift parameters of circulant block matrices, including

• shifting sets of $\delta \cdot \varepsilon$ bits within a packet followed by
• shifting sets of $\varepsilon$ bits within a set of $\delta \cdot \varepsilon$ bits followed by
• flipping the sets of $\varepsilon$ bits within the set of $\delta \cdot \varepsilon$ bits followed by
• shifting bits within a set of $\varepsilon$ bits whereby the shifting sets of $\varepsilon$ bits and the shifting of bits are based on the single shift parameter and the flipping is based on the sign of the single shit parameter;

✓ processing the packets of bits after the packets have been subjected to the said shifting operations to provide a codeword that corresponds to the block of data bits.

9. The method according to claim **8**, comprising:

✓ providing a parity check matrix, whereby the matrix is subdivided into $\alpha \cdot \beta$ rectangular blocks of size $q = \gamma \cdot \delta \cdot \varepsilon$ so that the parity check matrix is composed of q $\alpha$ rows and q·$\beta$ columns with $\alpha$ and $\beta$ being non-zero integer positive numbers, the rectangular blocks of size q are further subdivided into $\gamma \cdot \gamma$ rectangular blocks of size v, so that the rectangular blocks of size q are composed of v·$\gamma$ rows and v·$\gamma$ columns with $\gamma$ being non-zero integer positive number and the rectangular blocks of size v are further subdivided into $\delta \cdot \delta$ rectangular blocks of size w=$\varepsilon$, whereby $\delta$ equals a power of 2 and preferably 8 and whereby w is preferably equal to 4, so that the rectangular blocks of size v are composed of w·$\delta$ rows and w·$\delta$ columns with $\delta$ being non-zero integer positive number;

✓ setting a maximum value for w·$\delta$, whereby the maximum value of w·$\delta$ equals a power of 2 and preferably 32;
✓ splitting each packet of bits into a series of sets of equal number of bits, whereby each set includes no more bits than the maximum value w·$\delta$.

**10.** The method according to claim **9** comprising

✓ obtaining a codeword for each block of data bits, whereby the codeword has a number of bits that defines the codeword length;
✓ setting $\beta$ to a constant value and providing a set of values for $\alpha$;
✓ selecting $\alpha$ to control the code rate that is defined by the ratio of the number of information bits of a block of data over the codeword length.

**11.** The method according to any of claim **9 or 10,** comprising

✓ obtaining a codeword for each block of data bits, whereby the codeword has a number of bits that defines the codeword length;
✓ providing q to control the codeword length.

**12.** The method according to claim **11** comprising setting $\beta$, $\gamma$ and w to constant values and providing $\delta$ to control the codeword length.

## Patentansprüche

**1.** Einrichtung zum Codieren mit Low-Density-Parity-Check-Codes, umfassend Mittel zum Empfangen einer zu codierenden Informationsbitfolge und einen dünnbesetzten Matrix-Multiplikator **(1, 2, 3, 4, 10, 13),** der Folgendes beinhaltet

- Splittermittel **(14),** die so konfiguriert sind, dass sie die Informationsbitfolge in Bitpakete der Größe $\gamma \cdot \delta \cdot \varepsilon$ aufteilen, wobei $\gamma$, $\delta$, $\varepsilon$ von Null verschiedene, positive ganze Zahlen sind; und
- eine Kette von Komponenten **(16, 17, 18, 19, 20),** wobei die Komponenten Folgendes beinhalten:

- Speichermittel **(16),** die so konfiguriert sind, dass sie Sätze mit der gleichen Anzahl von $\delta \cdot \varepsilon$-Bits speichern, wobei diese Sätze ein Paket bilden;
- vier kaskadierte Verarbeitungsmittel **(17, 18, 19, 20),** die so konfiguriert sind, dass sie Binäroperationen mit den Paketen durchführen, und die so konfiguriert sind, dass sie die Binäroperationen auf zirkulierenden Blöcken basieren, wobei jeder zirkulierende Block durch zyklische Permutation einer diagonalen oder antidiagonalen Matrix gebildet und durch einen einzigen Verschiebungsparameter definiert wird, beinhaltend

- Level-1-Verschiebungsmittel **(17),** die so konfiguriert sind, dass sie Sätze von $\delta \cdot \varepsilon$-Bits innerhalb eines Pakets verschieben, gefolgt von
- Level-2-Verschiebungsmitteln **(18),** die so konfiguriert sind, dass sie Sätze von $\varepsilon$-Bits innerhalb eines Satzes von $\delta \cdot \varepsilon$-Bits verschieben, gefolgt von
- Vorzeichenverschiebungsmitteln **(19)** zwischen den Level-2-Verschiebungsmitteln **(18)** und Level-3-Verschiebungsmitteln **(20),** die so konfiguriert sind, dass sie Sätze von $\varepsilon$-Bits innerhalb eines Satzes von $\delta \cdot \varepsilon$-Bits umkehren, gefolgt von
- den Level-3-Verschiebungsmitteln **(20),** die so konfiguriert sind, dass sie Bits innerhalb eines Satzes von $\varepsilon$-Bits verschieben, wobei die Level-2-Verschiebungsmittel **(18)** und die Level-3-Verschiebungsmittel **(20)** so konfiguriert sind, dass sie die binären Operationen auf zirkulierenden Blöcken basieren, die durch den einzelnen Verschiebungsparameter definiert sind, und die Vorzeichenverschiebungsmittel **(19)** so konfiguriert sind, dass sie die binären Operationen auf dem Vorzeichen des einzelnen Verschiebungsparameters basieren

- einen Controller **(15),** der so konfiguriert ist, dass er die Verschiebungsparameter an die Verarbeitungsmittel **(17, 18, 20)** und die Speichermittel **(16)** liefert;

wobei die Codiereinrichtung weiter Mittel beinhaltet, um die Pakete zu empfangen, nachdem die Pakete durch den dünnbesetzten Matrix-Multiplikator verarbeitet worden sind, und um ein Codewort zu liefern, das der Informationsbitfolge entspricht.

2.  Einrichtung nach Anspruch 1, wobei der dünnbesetzte Matrix-Multiplikator (1, 2, 3, 4, 10, 13) eine Vielzahl ähnlicher Ketten von Komponenten (16, 17, 18, 19, 20) beinhaltet, die parallel angeordnet und für eine parallele Verarbeitung konfiguriert sind, und wobei der Controller (15) mit jeder Kette von Komponenten (16, 17, 18, 19, 20) verbunden ist, die parallel angeordnet sind.

3.  Einrichtung nach Anspruch 1 oder 2, umfassend Speichermittel, die so konfiguriert sind, dass sie Verschiebungsparameter speichern, die einen Master-Rechteckblock definieren, Eingabemittel, die so konfiguriert sind, dass sie einen eindeutigen Steuerparameter erhalten, und Verarbeitungsmittel, die so konfiguriert sind, dass sie die Verschiebungsparameter bestimmen, die die zirkulierenden Blöcke unter Verwendung des eindeutigen Steuerparameters und der Verschiebungsparameter, die den Master-Rechteckblock definieren, definieren.

4.  Einrichtung nach einem der Ansprüche 1 bis 3, die Mittel beinhaltet, die so konfiguriert sind, dass sie die Ausgabe des dünnbesetzten Matrix-Multiplikators empfangen und sie für weitere Verschiebeoperationen an denselben dünnbesetzten Matrix-Multiplikator umleiten.

5.  Einrichtung nach einem der Ansprüche 1 bis 4, umfassend eine Vielzahl ähnlicher dünnbesetzter Matrixmultiplikatoren (1, 2, 3, 4, 10, 13).

6.  Einrichtung nach Anspruch 5, wobei mindestens zwei dünnbesetzte Matrixmultiplikatoren (1, 2, 3) in Reihe angeordnet und so konfiguriert sind, dass die Ausgabe eines (1, 2) der mindestens zwei dünnbesetzten Matrixmultiplikatoren als Eingabe für den anderen (2, 3) der mindestens zwei dünnbesetzten Matrixmultiplikatoren geliefert wird.

7.  Einrichtung nach Anspruch 5 oder 6, wobei jeder der Vielzahl von dünnbesetzten Matrixmultiplikatoren (1, 2, 3, 4, 10) mit einem Speicher verbunden ist, der so konfiguriert ist, dass er die Verschiebungsparameter enthält, die einen zirkulierenden Block definieren, und so konfiguriert ist, dass er die Verschiebungsparameter in den Controller (15) des dünnbesetzten Matrixmultiplikators (1, 2, 3, 4, 10) eingibt.

8.  Verfahren, das von einer Vorrichtung zur Low-Density-Parity-Check-Codierung von Datenbitblöcken durchgeführt wird, umfassend

    - Definition von Bitpaketen, die die Datenbits der Größe $\gamma \cdot \delta \cdot \varepsilon$ eines Blocks beinhalten, wobei $\gamma$, $\delta$, $\varepsilon$ von Null verschiedene, positive ganze Zahlen sind;
    - Aufteilen jedes Pakets in Sätze mit gleicher Anzahl von $\delta \cdot \varepsilon$-Bits;
    - Bereitstellen von Verschiebungsparametern, die zirkulierende Blockmatrizen definieren, wobei jeder zirkulierende Block durch zyklische Permutation einer Diagonal-oder Antidiagonalmatrix gebildet und durch einen einzigen Verschiebungsparameter definiert wird;
    - Durchführen von aufeinanderfolgenden binären Verschiebungsoperationen auf der Grundlage der Verschiebungsparameter von zirkulierenden Blockmatrizen, beinhaltend

        - Verschieben von Sätzen von $\delta \cdot \varepsilon$-Bits innerhalb eines Pakets, gefolgt von
        - dem Verschieben von Sätzen von $\varepsilon$-Bits innerhalb eines Satzes von $\delta \cdot \varepsilon$-Bits, gefolgt von
        - dem Umkehren der Sätze von $\varepsilon$-Bits innerhalb des Satzes von $\delta \cdot \varepsilon$-Bits, gefolgt von
        - dem Verschieben von Bits innerhalb eines Satzes von $\varepsilon$ Bits
        wobei die Verschiebungssätze von $\varepsilon$-Bits und das Verschieben von Bits auf der Grundlage des einzelnen Verschiebungsparameters erfolgen und das Umkehren auf dem Vorzeichen des einzelnen Verschiebungsparameters beruht;

        - Verarbeiten der Bitpakete, nachdem die Pakete den genannten Verschiebeoperationen unterzogen wurden, um ein Codewort zu liefern, das dem Datenbitblock entspricht.

9.  Verfahren nach Anspruch 8, umfassend:

    - Bereitstellen einer Paritätsprüfungsmatrix, wobei die Matrix in $\alpha \cdot \beta$ rechteckige Blöcke der Größe $q=\gamma \cdot \delta \cdot \varepsilon$ unterteilt wird, sodass die Paritätsprüfungsmatrix aus $q \cdot \alpha$ Zeilen und $q \cdot \beta$ Spalten besteht, wobei $\alpha$ und $\beta$ von Null

verschiedene ganzzahlige positive Zahlen sind, die rechteckigen Blöcke der Größe q weiter in $\gamma \cdot \gamma$ rechteckige Blöcke der Größe v unterteilt werden, sodass die rechteckigen Blöcke der Größe q aus $v \cdot \gamma$ Zeilen und $v \cdot \gamma$ Spalten bestehen, wobei $\gamma$ eine positive ganze Zahl ungleich Null ist, und die rechteckigen Blöcke der Größe v weiter in $\delta \cdot \delta$ rechteckige Blöcke der Größe $w=\varepsilon$ unterteilt werden, wobei $\delta$ eine Potenz von 2 und vorzugsweise 8 ist und wobei w vorzugsweise gleich 4 ist, sodass die rechteckigen Blöcke der Größe v aus $w \cdot \delta$ Zeilen und $w \cdot \delta$ Spalten bestehen, wobei $\delta$ eine positive ganze Zahl ungleich Null ist;
- Festlegen eines Maximalwerts für $w \cdot \delta$, wobei der Maximalwert von $w \cdot \delta$ einer Potenz von 2 und vorzugsweise 32 entspricht;
- Aufteilen jedes Bitpakets in eine Reihe von Sätzen mit gleicher Anzahl von Bits, wobei jeder Satz nicht mehr Bits als den Maximalwert $w \cdot \delta$ beinhaltet.

10. Verfahren nach Anspruch 9, umfassend

- Erhalten eines Codeworts für jeden Block von Datenbits, wobei das Codewort eine Anzahl von Bits aufweist, die die Codewortlänge definiert;
- Festlegen von $\beta$ auf einen konstanten Wert und Bereitstellen eines Satzes von Werten für $\alpha$;
- Auswählen von $\alpha$ zur Steuerung der Coderate, die durch das Verhältnis zwischen der Anzahl der Informationsbits eines Datenblocks und der Codewortlänge definiert ist.

11. Verfahren nach einem der Ansprüche **9 oder 10,** umfassend

- Erhalten eines Codeworts für jeden Block von Datenbits, wobei das Codewort eine Anzahl von Bits aufweist, die die Codewortlänge definiert;
- Liefern von q zur Kontrolle der Codewortlänge.

12. Verfahren nach Anspruch **11,** umfassend das Festlegen von $\beta$, $\gamma$ und w auf konstante Werte und das Liefern von $\delta$ zur Steuerung der Codewortlänge.


**Revendications**

1. Appareil de codage avec des codes de contrôle de parité à faible densité comprenant un moyen pour recevoir une séquence de bits d'informations pour coder et un multiplicateur de matrice creuse (**1, 2, 3, 4, 10, 13**) qui inclut

- un moyen de division (**14**) configuré pour diviser la séquence de bits d'informations en paquets de bits de taille $\gamma \cdot \delta \cdot \varepsilon$, dans lequel $\gamma$, $\delta$, $\varepsilon$ sont des nombres entiers positifs non nuls ; et
- une chaîne de composants (**16, 17, 18, 19, 20**), selon lequel les composants incluent :

- un moyen de mémoire (**16**) configuré pour stocker des ensembles ayant un nombre égal de $\delta \cdot \varepsilon$ bits, lesquels ensembles forment un paquet ;
- quatre moyens de traitement en cascade (**17, 18, 19, 20**) configurés pour effectuer des opérations binaires sur les paquets et configurés pour baser les opérations binaires sur des blocs circulants, avec chaque bloc circulant étant établi par une permutation cyclique d'une matrice diagonale ou d'une matrice anti-diagonale et défini par un seul paramètre de décalage, incluant

- un moyen de décalage de niveau 1 (**17**) configuré pour décaler des ensembles de $\delta \cdot \varepsilon$ bits à l'intérieur d'un paquet, suivis par
- un moyen de décalage de niveau 2 (**18**) configuré pour décaler des ensembles de $\varepsilon$ bits à l'intérieur d'un ensemble de $\delta \cdot \varepsilon$ bits suivis par
- un moyen de décalage de signe (**19**) entre le moyen de décalage de niveau 2 (**18**) et le moyen de décalage de niveau 3 (**20**) configuré pour envoyer des ensembles de $\varepsilon$ bits à l'intérieur d'un ensemble de $\delta \cdot \varepsilon$ bits suivis par
- le moyen de décalage de niveau 3 (**20**) étant configuré pour décaler des bits à l'intérieur d'un ensemble de $\varepsilon$ bits, selon lequel le moyen de décalage de niveau 2 (**18**) et le moyen de décalage de niveau 3 (**20**) sont configurés pour baser les opérations binaires sur des blocs circulants définis par le seul paramètre de décalage et le moyen de décalage de signe (**19**) est configuré pour baser les opérations binaires sur le signe du seul paramètre de décalage

- un dispositif de commande **(15)** qui est configuré pour fournir les paramètres de décalage aux moyens de traitement **(17,18, 20)** et au moyen de mémoire **(16)** ;

l'appareil de codage incluant en outre un moyen pour recevoir les paquets après que les paquets ont été traités par le multiplicateur de matrice creuse et pour fournir un mot de code qui correspond à la séquence de bits d'informations.

2. Appareil selon la revendication **1,** selon lequel le multiplicateur de matrice creuse **(1, 2, 3, 4, 10, 13)** inclut une pluralité de chaînes similaires de composants **(16, 17, 18, 19, 20)** agencés en parallèle et configurés pour un traitement parallèle et selon lequel le dispositif de commande **(15)** est relié à chaque chaîne de composants **(16, 17, 18, 19, 20)** qui sont agencés en parallèle.

3. Appareil selon la revendication **1 ou 2,** comprenant un moyen de stockage configuré pour stocker des paramètres de décalage qui définissent un bloc rectangulaire maître, un moyen d'entrée configuré pour obtenir un unique paramètre de commande et un moyen de traitement configuré pour déterminer les paramètres de décalage qui définissent les blocs circulants à l'aide de l'unique paramètre de commande et les paramètres de décalage qui définissent le bloc rectangulaire maître.

4. Appareil selon l'une quelconque des revendications **1 à 3,** incluant un moyen configuré pour recevoir la sortie du multiplicateur de matrice creuse et la rediriger vers le même multiplicateur de matrice creuse pour d'autres opérations de décalage.

5. Appareil selon l'une quelconque des revendications **1 à 4,** comprenant une pluralité de multiplicateurs de matrice creuse similaires **(1, 2, 3, 4, 10, 13).**

6. Appareil selon la revendication **5,** selon lequel au moins deux multiplicateurs de matrice creuse **(1, 2, 3)** sont agencés en série et configurés de telle sorte que la sortie de l'un **(1, 2)** des au moins deux multiplicateurs de matrice creuse soit fourni en tant qu'entrée à l'autre **(2, 3)** des au moins deux multiplicateurs de matrice creuse.

7. Appareil selon la revendication **5 ou 6,** selon lequel chaque multiplicateur de matrice creuse de la pluralité de multiplicateurs de matrice creuse **(1, 2, 3, 4, 10)** est relié à une mémoire configurée pour contenir les paramètres de décalage, qui définissent un bloc circulant, et configuré pour entrer les paramètres de décalage dans le dispositif de commande **(15)** du multiplicateur de matrice creuse **(1, 2, 3, 4, 10).**

8. Procédé réalisé par un dispositif pour un codage de contrôle de parité à faible densité de blocs de bits de données comprenant

- la définition de paquets de bits incluant les bits de données de taille $\gamma \cdot \delta \cdot \varepsilon$ d'un bloc, dans lequel $\gamma$, $\delta$, $\varepsilon$ sont des nombres entiers positifs non nuls ;
- la division de chaque paquet en ensembles ayant un nombre égal de $\delta \cdot \varepsilon$ bits ;
- la fourniture de paramètres de décalage qui définissent des matrices de bloc circulant, avec chaque bloc circulant étant établi par une permutation cyclique d'une matrice diagonale ou d'une matrice anti-diagonale et défini par un seul paramètre de décalage ;
- la réalisation d'un décalage consécutif d'opérations binaires sur la base des paramètres de décalage de matrices de bloc circulant, incluant

- le décalage d'ensembles de $\delta \cdot \varepsilon$ bits à l'intérieur d'un paquet suivi par
- le décalage d'ensembles de $\varepsilon$ bits à l'intérieur d'un ensemble de $\delta \cdot \varepsilon$ bits suivi par
- l'envoi des ensembles de $\varepsilon$ bits à l'intérieur de l'ensemble de $\delta \cdot \varepsilon$ bits suivi par
- le décalage de bits à l'intérieur d'un ensemble de $\varepsilon$ bits

selon lequel les ensembles de décalage de $\varepsilon$ bits et le décalage de bits sont basés sur le seul paramètre de décalage et l'envoi est basé sur le signe du seul paramètre de décalage ;

- le traitement des paquets de bits après que les paquets ont été soumis auxdites opérations de décalage pour fournir un mot de code qui correspond au bloc de bits de données.

9. Procédé selon la revendication **8** comprenant :

- la fourniture d'une matrice de contrôle de parité, selon lequel la matrice est subdivisée en $\alpha \cdot \beta$ blocs rectan-

gulaires de taille q = $\gamma \cdot \delta \cdot \varepsilon$ de telle sorte que la matrice de contrôle de parité soit composée de q·$\alpha$ rangées et de q·$\beta$ colonnes avec $\alpha$ et $\beta$ étant des nombres entiers positifs non nuls, les blocs rectangulaires de taille q sont en outre subdivisés en $\gamma \cdot \gamma$ blocs rectangulaires de taille v de telle sorte que les blocs rectangulaires de taille q soient composés de v·$\gamma$ rangées et de v·$\gamma$ colonnes avec $\gamma$ étant un nombre entier positif non nul et les blocs rectangulaires de taille v sont en outre subdivisés en $\delta \cdot \delta$ blocs rectangulaires de taille w = $\varepsilon$, selon lequel $\delta$ est égal à une puissance de 2 et, de préférence, à 8 et selon lequel w est, de préférence, égal à 4 de telle sorte que les blocs rectangulaires de taille v soient composés de w·$\delta$ rangées et de w·$\delta$ colonnes avec $\delta$ étant un nombre entier positif non nul ;
- la fixation d'une valeur maximale pour w·$\delta$, selon lequel la valeur maximale de w·$\delta$ est égale à une puissance de 2 et, de préférence, à 32 ;
- la division de chaque paquet de bits en une série d'ensembles de nombre égal de bits, selon lequel chaque ensemble inclut pas plus de bits que la valeur maximale w·$\delta$.

10. Procédé selon la revendication **9** comprenant

- l'obtention d'un mot de code pour chaque bloc de bits de données, selon lequel le mot de code présente un nombre de bits qui définit la longueur de mot de code ;
- la fixation de $\beta$ à une valeur constante et la fourniture d'un ensemble de valeurs pour $\alpha$ ;
- la sélection de $\alpha$ pour commander le débit de code qui est définit par le rapport du nombre de bits d'informations d'un bloc de données sur la longueur de mot de code.

11. Procédé selon l'une quelconque des revendications **9 ou 10** comprenant

- l'obtention d'un mot de code pour chaque bloc de bits de données, selon lequel le mot de code présente un nombre de bits qui définit la longueur de mot de code ;
- la fourniture de q pour commander la longueur de mot de code.

12. Procédé selon la revendication **11,** comprenant la fixation de $\beta$, $\gamma$ et w à des valeurs constantes et la fourniture de $\delta$ pour commander la longueur de mot de code.

EP 2 951 926 B1

size of $\bar{x}$      size of $\bar{p}_1$      size of $\bar{p}_2$

$n-m=(\beta-\alpha)\cdot q$

$k\cdot q$

B

T

$m = \alpha\cdot q$

A

C   D   E

$l\cdot q$

$n=\beta\cdot q$

size of $\bar{c}$

▦ Element that can be either zero or non-zero

☐ Element that is zero

■ Element that is non-zero

# Figure 1

q-Element in Matrix H

r-Element in q-Element

u-Element in r-Element

Figure 2

Figure 3

Figure 4

Figure 5

Figure 6

Figure 7

EP 2 951 926 B1

Figure 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2010047662 A

**Non-patent literature cited in the description**

- **THOMAS J. RICHARDSON ; RÜDIGER L. UR-BANKE.** Efficient Encoding of Low-Density Parity-Check Codes. *IEEE Transactions on Information Theory,* February 2001, vol. 47 (2), 638-656